# EUROPÄISCHE PATENTSCHRIFT

(11) **EP 3 526 816 B1**
(45) Veröffentlichungstag und Bekanntmachung des Hinweises auf die Patenterteilung: **30.09.2026**
(21) Anmeldenummer: 17784630.0
(22) Anmeldetag: 13.10.2017
(51) Int. Cl.: H10K 39/30, H10K 39/32, H10K 71/12, B81C 1/00

(54) **MIKROSTRUKTURIERTES ORGANISCHES SENSORBAUELEMENT UND VERFAHREN ZU DESSEN HERSTELLUNG**
MICROSTRUCTURED ORGANIC SENSOR COMPONENT AND METHOD FOR PRODUCING SAME
COMPOSANT DE DÉTECTION ORGANIQUE MICROSTRUCTURÉ ET PROCÉDÉ DE FABRICATION DUDIT COMPOSANT

(30) Priorität: 14.10.2016 DE 102016220086
(43) Veröffentlichungstag der Anmeldung: 21.08.2019
(73) Patentinhaber: Fraunhofer-Gesellschaft zur Förderung der angewandten Forschung e.V., 80686 München (DE)
(72) Erfinder: RICHTER, Bernd, 01159 Dresden (DE); WARTENBERG, Philipp, 01097 Dresden (DE); FEHSE, Karsten, 01109 Dresden (DE); JAHNEL, Matthias, 01159 Dresden (DE)
(74) Vertreter: Schenk, Markus
(86) Internationale Anmeldenummer: PCT/EP2017/076192
(87) Internationale Veröffentlichungsnummer: WO 2018/069501

(56) Entgegenhaltungen:
- WO-A1-2007/017474
- GB-A- 2 427 308
- KANG N S ET AL: "Partitioning of the organic layers for the fabrication of high efficiency organic photovoltaic devices", ORGANIC ELECTRONICS, ELSEVIER, AMSTERDAM, NL, vol. 10, no. 6, 31 May 2009 (2009-05-31), pages 1091 - 1096, XP026348791, ISSN: 1566-1199, [retrieved on 20090531]
- MOON GYU HAN ET AL: "Narrow-Band Organic Photodiodes for High-Resolution Imaging", ACS APPLIED MATERIALS & INTERFACES, vol. 8, no. 39, 23 September 2016 (2016-09-23), US, pages 26143 - 26151, XP055440235, ISSN: 1944-8244, DOI: 10.1021/acsami.6b07735

## Beschreibung

Die Erfindung betrifft organische Sensorbauelemente sowie Verfahren zu deren Herstellung. Aus der DE 10 2006 049 120 A1 ist ein Sensorbauelement bekannt, bei dem eine organisch basierte sensoraktive Schicht zwischen einer unteren Elektrode und einer oberen Elektrode angeordnet ist.

Das Dokument WO 2007/017474 A1 offenbart einen flächenhaften organischen Fotodetektor, aufweisend eine strukturierte, mehrere Teilelektroden umfassende erste Elektrode, eine zweite Elektrode, wenigstens eine erste organische Schicht und eine zweite organische Schicht. Die beiden organischen Schichten sind zwischen den beiden Elektroden angeordnet und entsprechend der ersten Elektrode strukturiert, sodass die beiden organischen Schichten in mehrere, den einzelnen Teilelektroden der ersten Elektrode zugeordneten aktive Bereiche unterteilt sind.

Das Dokument KANG N S ET AL, "Partitioning of the organic layers for the fabrication of high efficiency organic photovoltaic devices", ORGANIC ELECTRONICS, ELSEVIER, AMSTERDAM, NL, Band 10, Nr. 6, ISSN 1566-1199, (20090531), Seiten 1091 - 1096, offenbart eine photovoltaische Einrichtung mit partitionierten organischen Schichten.

Aus dem Dokument GB 2 427 308 A ist ein Licht-Licht-Konverter bekannt, der einen Lichtempfänger und einen Lichtsender, wobei der Lichtempfänger und/oder der Lichtsender einen polymeren Halbleiter aufweisen.

Das Dokument MOON GYU HAN ET AL, "Narrow-Band Organic Photodiodes for High-Resolution Imaging", ACS APPLIED MATERIALS & INTERFACES, US, (20160923), Band. 8, Nr. 39, doi:10.1021/acsami.6b07735, ISSN 1944-8244, Seiten 26143 - 26151, offenbart eine schmalbandige organische Photodiode.

Aufgabe der Erfindung ist es, ein derartiges Sensorbauelement zu verbessern.

Die Aufgabe wird gelöst durch ein mikrostrukturiertes organisches Sensorbauelement gemäß Anspruch 1.

Die Begriffe horizontal, oben, unten beziehen sich in dieser Schrift auf eine Normallage des mikrostrukturierten organischen Sensorbauelements, bei dem die Substratschicht als unterste Schicht parallel zur Erdoberfläche angeordnet ist.

Die Verwendung einer organischen Sensorschicht weist im Vergleich zur Verwendung einer anorganischen Sensorschicht mehrere Vorteile auf. So kann die organische Sensorschicht in einfacher Weise durch ganzflächiges Aufschleudern, durch andere ganzflächige Flüssigphasenprozesse oder durch thermische Verdampfungsprozesse auf die darunter liegenden Schichten aufgebracht werden, wobei eine direkte elektrische Kontaktierung entsteht, sodass aufwändig herzustellende und insbesondere bei thermischer Beanspruchung fehlfunktionsanfällige Bump-Kontakte entbehrlich sind. Dabei ergibt sich neben der erhöhten Funktionssicherheit eine deutliche Kostenersparnis. Weiterhin können die genannten Verfahren im Regelfall bei Temperaturen von unter 80 °C durchgeführt werden, so dass die darunter liegenden Schichten auch aus Materialien bestehen können, die temperaturempfindlich sind.

Darüber hinaus stehen organische Materialien für sensorische Anwendungen in wesentlich größerer Zahl zur Verfügung, so dass die Leistungsfähigkeit des Sensorbauelements durch eine gezieltere Auswahl der Materialien der Sensorschicht optimiert werden kann.

Weiterhin kann eine organische Sensorschicht oberhalb einer in einen Chip integrierten Ansteuer- und Ausleseelektronik angeordnet werden, was bei einer anorganischen Sensorschicht nicht möglich ist, da dort die Ansteuer- und Ausleseelektronik in der Ebene der anorganischen Sensorschicht angeordnet werden muss. Hierdurch kann ein erhöhter Füllfaktor realisiert werden, wobei der Füllfaktor den Anteil der sensorisch aktiven Fläche an der Gesamtfläche der Ebene angibt, so dass letztlich ein kompakteres und empfindlicheres Sensorbauelement realisierbar ist. Zudem kann so auf Einrichtungen zur Konzentration der Wirkung der zu erfassenden technischen Größe auf die sensorisch aktive Fläche verzichtet werden. Handelt es sich beispielsweise um ein optisches Sensorbauelement, so kann bei Verwendung einer organischen Sensorschicht auf die bei anorganischen Sensorschichten üblichen Mikrolinsen zum Fokussieren von einfallendem Licht auf die sensorisch aktive Fläche verzichtet werden.

Bei der elektrischen Größe kann es sich beispielsweise um eine Spannung, um einen Strom oder um einen elektrischen Widerstand handeln. Jedes der Sensorsegmente ist dabei so ausgebildet, dass es einen Wert der elektrischen Größe liefert, welcher idealerweise unabhängig von den durch die anderen Sensorsegmente gelieferten Werten der elektrischen Größe ist. Die Sensorsegmente üben daher die Funktion von Einzelsensoren aus. Jedes der Sensorsegmente ist dabei sowohl mit der ersten Elektrodenschicht als auch mit der zweiten Elektrodenschicht elektrisch verbunden, also kontaktiert, so dass die gelieferten Werte über die erste Elektrodenschicht und über die zweite Elektrodenschicht ausgelesen werden können.

Die von den Sensorsegmenten gelieferten Werte der elektrischen Größe können dabei unabhängig voneinander ausgelesen werden, da wenigstens eine der Elektrodenschichten derart strukturiert ist, dass eine Vielzahl von horizontal beanstandenden Elektrodensegmenten gebildet ist, wobei jedes der Sensorsegmente mit wenigstens einem zugeordneten Elektrodensegment elektrisch verbunden ist, welches mit keinem der anderen Sensorsegmente elektrisch verbunden ist. Die Elektrodensegmente fungieren dabei als Einzelelektroden für einen Einzelsensor.

Dabei kann die erste Elektrodenschicht strukturiert und die zweite Elektrodenschicht unstrukturiert sein. Es ist aber auch möglich, dass umgekehrt die erste Elektrodenschicht unstrukturiert und die zweite Elektrodenschicht strukturiert ist. Die jeweils umstrukturierte Elektrodenschicht wirkt dann als gemeinsame Elektrode für sämtliche Sensoren.

Darüber hinaus ist es auch möglich, dass beide Elektrodenschichten strukturiert sind. In diesem Fall braucht eine gemeinsame Elektrode nicht vorgesehen werden.

Bei der vorliegenden Erfindung können beispielsweise lithographische Verfahren genutzt werden, um die Sensorschicht mit hoher Präzision zu strukturieren. Ebenso können lithographische Verfahren genutzt werden, um die eine oder mehrere Funktionsschichten herzustellen. Im Rahmen derartiger lithographischer Verfahren können auch fluorierte Fotolacke verwendet werden, die auch empfindliche organische Materialien nicht angreifen.

Durch die Strukturierung der Sensorschicht, so dass eine Vielzahl von horizontal beanstandeten Sensorsegmenten gebildet ist, wird, im Vergleich zum Sensorbauelement der DE 10 2006 049120 A1 mit seiner unstrukturierten Sensorschicht, ein Übersprechen bzw. ein Überkoppeln zwischen den Sensorsegmenten stark verringert.

Dadurch, dass die eine oder mehrere Funktionsschichten horizontal zwischen den Sensorsegmenten gelegene Zwischenräume zumindest teilweise ausfüllen, werden Übersprech- bzw. Überkoppeleffekte weiter verringert.

Die Funktionsschicht kann die Sensorschicht vertikal und/oder horizontal ganz oder teilweise bedecken.

Gemäß einer vorteilhaften Weiterbildung der Erfindung weisen die Sensorsegmente eine maximale horizontale Erstreckung auf, welche kleiner als 50 µm ist.

Die Strukturierung und das Ausfüllen der Zwischenräume sind gerade bei fortschreitender Miniaturisierung, insbesondere im µm- bzw. im sub-µm-Bereich, ein wesentlicher Vorteil, da mit kleiner werdenden Einzelsensoren auch der Einfluss von Übersprech- bzw. Überkoppeleffekte zwischen den Einzelsensoren stärker wird Die Funktionsschicht kann dann ebenfalls im Bereich kleiner als 50µm strukturiert sein.

Nach einer zweckmäßigen Weiterbildung der Erfindung umfassen die eine oder mehrere Funktionsschichten eine Passivierungsschicht. Unter einer Passivierungsschicht wird dabei eine Schicht verstanden, die elektrische und/oder elektromagnetische Vorgänge unterbindet. Dabei kann es sich beispielsweise um eine elektrische Passivierungsschicht handeln, welche unerwünschte elektrische Ströme verhindert. Ebenso kann es sich um eine elektromagnetische Passivierungsschicht handeln, welche unerwünschte elektromagnetische Strahlung verhindert. Selbstverständlich sind auch Passivierungsschichten möglich, welche beide genannten Funktionen erfüllen.

Gemäß einer vorteilhaften Weiterbildung der Erfindung umfasst die organische Sensorschicht mehrere parallel zu den anderen Schichten angeordnete Teilsensorschichten. Dabei kann es sich beispielsweise um Teilsensorschichten handeln, an deren Übergang ein pn-Übergang gebildet ist.

Nach einer vorteilhaften Weiterbildung der Erfindung sind die Sensorsegmente nach Art einer zweidimensionalen Matrix angeordnet. Gerade in einer Matrix aus organischen Einzelsensoren können die Übersprech- bzw. Überkoppeleffekte zwischen den Einzelsensoren deutlich verringert werden, wenn die Einzelsensoren strukturiert sind und zusätzlich die Zwischenräume zwischen den einzelnen Sensoren zumindest teilweise durch eine oder mehrere Funktionsschichten ausgefüllt sind.

Nach einer zweckmäßigen Weiterbildung der Erfindung sind die erste und/oder die zweite Elektrodenschicht als organische Schicht, als Metallschicht oder als Metall-Oxid-Multischicht ausgebildet.

Gemäß einer zweckmäßigen Weiterbildung der Erfindung ist die Substratschicht als Glasschicht, als Kunststoffschicht oder als Siliziumschicht ausgebildet.

Die Substratschicht kann starr oder flexibel ausgelegt sein und/oder aktive Bauelemente und/oder ein oder mehrere Verdrahtungsebenen enthalten. Dies beinhaltet z.B. auch Glas- oder Plastiksubstrate mit aktiven TFT-Transistoren oder Siliziumwafer mit aktiven Bauelementen.

Nach einer vorteilhaften Weiterbildung der Erfindung sind die Sensorsegmente optische Sensorsegmente, sodass das mikrostrukturierte organische Sensorbauelement ein mikrostrukturiertes optisches organisches Sensorbauelement ist.

Die Erfindung ist insbesondere für mikrostrukturierte optische organische Sensorbauelemente geeignet. Die mikrostrukturierten optischen Sensorsegmente können auf verschiedensten Substratschichten aufgebracht werden. Speziell die Kombination mit TFT- oder CMOS-Substraten ermöglicht die Herstellung von neuartigen und hoch leistungsfähigen optischen Sensorbauelementen. Der Aufbau der organischen Sensorsegmente kann für verschiedene Wellenlängenbereiche (UV/VIS/NIR) ausgelegt werden. Hierbei kann die Mikrostrukturierung der optischen organischen Sensorschicht und der anderen anorganischen oder organischen Schichten beispielsweise mittels Lithographie umgesetzt werden. Bei den optischen Sensorsegmenten kann es sich insbesondere um Photodioden handeln.

Die Erfindung kann allgemein für die Herstellung von optischen Sensorbauelementen im ultravioletten, im sichtbaren bis hin zum infraroten Spektralbereich verwendet werden. Derartige Sensorbauelemente können insbesondere in der Sicherheits- und Militärtechnik, hier insbesondere als NIR- oder IR-Sensoren, in der Meteorologietechnik, hier insbesondere als UV Sensoren, in der Lebensmittel-und Landwirtschaftstechnik, hier insbesondere als NIR-Sensoren, in der Qualitätssicherung und im Automobilbereich, hier insbesondere als in NIR-Sensor, in der Kameratechnik, hier insbesondere im sichtbaren Spektralbereich, und in der hyperspektralen Aufnahmetechnik verwendet werden.

Gemäß einer zweckmäßigen Weiterbildung der Erfindung sind die erste und/oder die zweite Elektrodenschicht transparent oder semitransparent.

Unter einer transparenten Elektrodenschicht kann eine solche Elektrodenschicht verstanden werden, welche mindestens 90 % eines einfallenden Lichtes hindurch lässt. Weiterhin kann unter einer semitransparenten Elektrodenschicht eine solche Elektrodenschicht verstanden werden, welche mindestens 50 % eines einfallenden Lichtes hindurch lässt.

Wenn die erste Elektrodenschicht transparent bzw. semitransparenten ist, kann der Lichteinfall auf die organische Sensorschicht durch die Substratschicht hindurch erfolgen. Wenn hingegen die zweite Elektrodenschicht transparent bzw. semitransparenten ist, kann der Lichteinfall von der substratabgewandten Seite erfolgen.

Nach einer zweckmäßigen Weiterbildung der Erfindung weisen eine Gruppe der Sensorsegmente eine spektrale Empfindlichkeit und mindestens eine weitere Gruppe der Sensorsegmente eine jeweils von den spektralen Empfindlichkeiten der anderen Gruppen abweichende spektrale Empfindlichkeit auf.

Die Sensorsegmente mit der ersten spektralen Empfindlichkeit und die Sensorsegmente mit der zweiten spektralen Empfindlichkeit können dabei getrennt ausgelesen werden und ermöglichen so eine spektrale Unterscheidung (z.B. UV/VIS/NIR) ohne die Verwendung von zusätzlichen Filtern.

Gemäß einer vorteilhaften Weiterbildung der Erfindung weisen die Sensorsegmente einen Bereich mit einer spektralen Empfindlichkeit und mindesten einen weiteren Bereich mit einer davon abweichenden spektralen Empfindlichkeit auf.

Die Verwendung substrukturierter Sensorsegmente ermöglicht die Realisierung von besonders breitbandigen optischen Sensorbauelementen. Derartige breitbandige optische Sensorbauelemente ermöglichen hyperspektrale Aufnahmen. Unter hyperspektralen Aufnahmen versteht man Aufnahmen, die durch die Aufzeichnung von sehr vielen, eng beieinanderliegenden Wellenlängen erzeugt sind.

Gemäß der Erfindung sind auf der Substratschicht eine oder mehrere Leuchtdioden ausgebildet.

Dabei kann mindestens eine Leuchtdiode, mindestens ein eindimensionale Leuchtdiodenanordnung oder mindestens eine zweidimensionale Leuchtdiodenanordnung Leuchtdioden-Array, jeweils mit einem oder mehreren Emittern, auf der Substratschicht angeordnet sein. Die Sensorsegmente und Leuchtdioden sind ineinander verschachtelt.

Auf diese Weise wird das Sensorbauelement zu einem Multifunktionsbauelement, welche neben der Sensorfunktion auch eine Beleuchtungsfunktion aufweist.

Nach einer vorteilhaften Weiterbildung der Erfindung umfassen die Schichten eine oder mehrere Lichtkoppelschichten, welche zum Verbessern der Lichtkoppeleffizienz beim Einkoppeln von Licht in eine der Elektrodenschichten und/oder beim Auskoppeln von Licht aus einer der Elektrodenschichten ausgebildet sind, wobei auf der der organischen Sensorschicht abgewandten Seite der ersten Elektrodenschicht und/oder auf der der organischen Sensorschicht abgewandten Seite der zweite Elektrodenschicht jeweils eine der Lichtkoppelschichten vorgesehen ist.

Eine derartige Lichtkoppelschicht kann die Lichteinkopplung bzw. die Lichtauskopplung in bzw. aus den Elektrodenschichten für den verwendeten Wellenlängenbereich. Darüber hinaus kann eine derartige Lichtkoppelschicht eine weitere Funktion als Pufferschicht zur Reduktion von Schichtspannungen gegenüber den angrenzenden Schichten aufweisen.

Die Lichtkuppelschichten können jeweils durch geeignete Formgebung und/oder durch die Verwendung von Materialien mit einem geeigneten Brechungsindex eine Verbesserung der Lichtkoppeleffizienz bewirken. Insbesondere können sie so ausgebildet sein, dass eine Totalreflexion von Licht vermieden ist.

Gemäß einer zweckmäßigen Weiterbildung der Erfindung umfassen die Schichten eine oder mehrere Filterschichten, welche zum spektralen Filtern von Licht beim Einkoppeln von Licht in eine der Elektrodenschichten und/oder beim Auskoppeln von Licht aus einer der Elektrodenschichten ausgebildet sind, wobei auf der der organischen Sensorschicht abgewandten Seite der ersten Elektrodenschicht und/oder auf der der organischen Sensorschicht abgewandten Seite der zweite Elektrodenschicht jeweils eine der Filterschichten vorgesehen ist.

Hierzu können strukturierte und/oder unstrukturierte optische Filterschichten (z.B. Absorbtions-, Interferenz- oder Plasmonenfilter) zwischen der Substratschicht und der ersten Elektrodenschicht und/oder auf der zweiten Elektrodenschicht aufgebracht sein. Hierbei kann optional eine Pufferschicht zwischen der jeweiligen Filterschicht und der jeweiligen Elektrodenschicht zum Einsatz kommen.

Durch derartige optische Filterschichten kann das Sensorbauelement bezüglich seiner spektralen Eigenschaften modifiziert werden. Absorptions- und Interferenzfilter können eingesetzt werden, um dem Sensorbauelement eine schmal begrenzte spektrale Empfindlichkeit zu verleihen.

Gemäß einer zweckmäßigen Weiterbildung der Erfindung sind die eine oder mehreren Filterschichten so strukturiert, dass eine Vielzahl von horizontal nebeneinander liegenden Filtersegmenten gebildet ist, so dass jedem der Sensorsegmente wenigstens eines der Filtersegmente der jeweiligen Filterschicht zugeordnet ist, wobei eine erste Gruppe der Filtersegmente der jeweiligen Filterschicht eine erste spektrale Charakteristik und eine zweite Gruppe der Filtersegmente der jeweiligen Filterschicht eine von der ersten spektralen Charakteristik abweichende zweite spektrale Charakteristik aufweisen.

Hierdurch ist es möglich, die spektralen Empfindlichkeiten der Sensorsegmente gezielt zu beeinflussen.

Gemäß einer zweckmäßigen Weiterbildung der Erfindung ist eine Dünnschichtverkapselung zum Schutz wenigstens eines Teiles der Schichten vor der Einwirkung von Feuchtigkeit vorgesehen.

Die Dünnschichtverkapselung kann an der Ober- und/oder der Unterseite des Bauelements aufgebracht sein und beispielsweise ALD, CVD, Vitex, VTE, PVD oder Kombinationen davon enthalten. Die Dünnschichtverkapselung kann mit oder ohne Pufferschicht aufgebracht sein.

Nach einer zweckmäßigen Weiterbildung der Erfindung ist die Dünnschichtverkapselung zur Verhinderung eines horizontalen Eindringens von Flüssigkeit zwischen zumindest einige der Schichten ausgebildet.

Hierbei kann die Dünnschichtverkapselung so strukturiert sein, dass nur die empfindlichen Gebiete überdeckt sind und dass eine seitliche Diffusion/Migration von z.B. von Wasser verhindert bzw. minimiert ist.

Gemäß einer vorteilhaften Weiterbildung der Erfindung ist wenigstens eine der Schichten bei ihrer Herstellung durch Blitzlampenbelichtung getrocknet.

Hierdurch kann eine besonders schnelle Trocknung der jeweiligen Schicht erreicht werden. Dabei können beispielsweise die organische Sensorschicht, welche aus in einer Flüssigphase abgeschiedenen Materialien hergestellt ist, die Filterschicht oder die Dünnschichtverkapselung durch Blitzlampenbelichtung getrocknet sein.

Die Blitzlampenbelichtung ("flash-lamp-annealing") kann dünne Schichten lokal sehr kurz erwärmen, ohne das darunterliegende Substrat (CMOS, Folie, Papier) zu beschädigen. Mit dieser Technologie ist es potentiell möglich organische Materialien mit darunterliegenden Schichten zu kombinieren, die durch ihre stark gegensätzlichen Temperaturbelastungen bisher nicht vereinbar waren.

Beispielsweise kann so eine Filterschicht ausgehärtet werden, ohne eine darunter liegende organische Sensorschicht zu zerstören, selbst wenn die Filterschicht kurzzeitig auf eine Temperatur gebracht wird, welche höher ist als die maximale für die organische Sensorschicht zulässige Temperatur.

Die Blitzlampenbelichtung kann durch Einzelpulse oder durch Pulsfolgen mit Belichtungszeiten von weniger als 1s erfolgen, so dass die thermische Belastung der herzustellenden Schicht als auch der zuvor hergestellten Schichten gering gehalten werden kann.

Weiterhin wird die Aufgabe gelöst durch einen Verfahren zur Herstellung eines mikrostrukturierten organischen Sensorbauelements mit parallel zueinander ausgerichteten Schichten, wobei die Schichten eine Sensorschicht umfassen, welche so strukturiert ist, dass eine Vielzahl horizontal beabstandeten Sensorsegmente gebildet ist, wobei jedes Sensorsegment aus einem oder mehreren Bereichen besteht, insbesondere nach einem der Ansprüche 1-20, wobei das Verfahren folgende Schritte in folgender Reihenfolge umfasst:
a) Bereitstellen einer Substratschicht zum Tragen der weiteren Schichten, wobei an der Substratschicht eine erste Elektrodenschicht zum Kontaktieren einer organischen Sensorschicht zum Umwandeln einer zu erfassenden technischen Größe in eine elektrische Größe angeordnet ist;
b) ganzflächiges Aufbringen mindestens einer organischen Sensormaterialschicht auf einen Verbund aus der Substratschicht und der erste Elektrodenschicht;
c) ganzflächiges Aufbringen einer ersten Fotolackschicht auf die organische Sensormaterialschicht;
d) selektives Belichten der ersten Fotolackschicht, so dass eine erste gehärtete Fotolackstruktur mit horizontal beabstandeten ersten gehärteten Fotolackstruktursegmenten und eine erste nicht gehärtete Fotolackstruktur entstehen;
e) Entfernen der ersten nicht gehärteten Fotolackstruktur mittels eines ersten Entwicklungslösungsmittels;
f) Aufbringen eines ersten Lösungsmittels, um so einen nicht von der ersten gehärteten Fotolackstruktur bedeckten Teil der zumindest einen organischen Sensormaterialschicht zu entfernen, sodass durch einen verbleibenden Teil der mindestens einen organischen Sensormaterialschicht jeweils wenigstens einer der Bereiche der Sensorsegmente der Sensorschicht gebildet wird, sodass jedes der Sensorsegmente von der ersten Elektrodenschicht kontaktiert ist;
g) Entfernen der ersten gehärteten Fotolackstruktur mittels eines zweiten Lösungsmittels;
h) ganzflächiges Aufbringen einer zweiten Fotolackschicht auf die Sensorsegmente und auf horizontal zwischen den Sensorsegmenten gelegene Zwischenräume;
i) selektive Belichtung der zweiten Fotolackschicht, so dass eine zweite gehärtete Fotolackstruktur mit horizontal beabstandeten zweiten gehärteten Fotolackstruktursegmenten und eine zweite nicht gehärtete Fotolackstruktur entstehen, wobei an jedem Sensorsegment wenigstens eines der zweiten gehärteten Fotolackstruktursegmente ausgebildet ist;
j) Entfernen der zweiten nicht gehärteten Fotolackstruktur mittels eines zweiten Entwicklungslösungsmittels;
k) ganzflächiges Aufbringen einer Funktionsschicht auf die Sensorsegmente mit den zweiten gehärteten Fotolackstruktursegmenten und die horizontal zwischen den Sensorsegmenten gelegenen Zwischenräume;
l) ganzflächiges Aufbringen einer dritten Fotolackschicht auf die Funktionsschicht;
m) selektive Belichtung der dritten Fotolackschicht, so dass eine dritte gehärtete Fotolackstruktur und eine dritte nicht gehärtete Fotolackstruktur mit horizontal beabstandeten nicht gehärteten Fotolackstruktursegmenten entstehen, wobei jedem der zweiten gehärteten Fotolackstruktursegmente eines der nicht gehärteten Fotolackstruktursegmente der dritten Fotolackschicht zugeordnet ist;
n) Entfernen der dritten nicht gehärteten Fotolackstruktur mittels eines dritten Entwicklungslösungsmittels;
o) Aufbringen eines dritten Lösungsmittels, um so einen nicht von der gehärteten Fotolackstruktur bedeckten Teil der Funktionsschicht und die zweiten gehärteten Fotolackstruktursegmente zu entfernen, sodass die Funktionsschicht so strukturiert ist, dass die horizontal zwischen den Sensorsegmenten gelegenen Zwischenräume zumindest teilweise durch die Funktionsschicht ausgefüllt sind;
p) Entfernen der dritten gehärteten Fotolackstruktur mittels eines vierten Lösungsmittels; und
q) ganzflächiges Aufbringen einer zweite Elektrodenschicht zum Kontaktieren der organischen Sensorschicht auf die Sensorsegmente und die Funktionsschicht, sodass jedes der Sensorsegmente von der zweiten Elektrodenschicht kontaktiert ist;
wobei wenigstens eine der Elektrodenschichten so strukturiert wird, dass eine Vielzahl von horizontal beabstandeten Elektrodensegmenten gebildet wird, so dass jedem der Sensorsegmente wenigstens eines der Elektrodensegmente der jeweiligen Elektrodenschicht zugeordnet ist.

In einem weiteren Aspekt wird die Aufgabe gelöst durch einen Verfahren zur Herstellung eines mikrostrukturierten organischen Sensorbauelements mit parallel zueinander ausgerichteten Schichten, wobei die Schichten eine Sensorschicht umfassen, welche so strukturiert ist, dass eine Vielzahl horizontal beabstandeten Sensorsegmente gebildet ist, wobei jedes Sensorsegment aus einem oder mehreren Bereichen besteht, insbesondere nach einem der Ansprüche 1-20, wobei das Verfahren folgende Schritte in folgender Reihenfolge umfasst:
a) Bereitstellen einer Substratschicht zum Tragen der weiteren Schichten, wobei an der Substratschicht eine erste Elektrodenschicht zum Kontaktieren einer organischen Sensorschicht zum Umwandeln einer zu erfassenden technischen Größe in eine elektrische Größe angeordnet ist;
b) ganzflächiges Aufbringen einer ersten Fotolackschicht auf einen Verbund aus der Substratschicht und der ersten Elektrodenschicht;
c) selektives Belichten der ersten Fotolackschicht, so dass eine erste gehärtete Fotolackstruktur und eine erste nicht gehärtete Fotolackstruktur mit ersten horizontal beabstandeten gehärteten Fotolackstruktursegmenten entstehen;
d) Entfernen der ersten nicht gehärteten Fotolackstruktur mittels eines ersten Entwicklungslösungsmittels;
e) ganzflächiges Aufbringen einer organischen Sensormaterialschicht auf einen Verbund aus der Substratschicht, der ersten Elektrodenschicht und der ersten gehärteten Fotolackstruktur;
f) Aufbringen eines ersten Lösungsmittels, um so die erste gehärtete Fotolackstruktur und den darauf angeordneten Teil der organischen Sensormaterialschicht zu entfernen, sodass durch einen verbleibenden Teil der mindestens einen organischen Sensormaterialschicht jeweils wenigstens einer der Bereiche der Sensorsegmente der Sensorschicht gebildet wird, sodass jedes der Sensorsegmente von der ersten Elektrodenschicht kontaktiert ist;
g) ganzflächiges Aufbringen einer zweiten Fotolackschicht auf einen Verbund aus der Substratschicht, der ersten Elektrodenschicht und den Sensorsegmenten;
h) selektives Belichten der zweiten Fotolackschicht, so dass eine zweite gehärtete Fotolackstruktur mit zweiten horizontal beabstandeten gehärteten Fotolackstruktursegmenten und eine zweite nicht gehärtete Fotolackstruktur entstehen, wobei an jedem Sensorsegment wenigstens ein gehärtetes Fotolackstruktursegment der zweiten Fotolackschicht ausgebildet ist;
i) Entfernen der zweiten nicht gehärteten Fotolackstruktur mittels eines zweiten Entwicklungslösungsmittels;
j) ganzflächiges Aufbringen einer Funktionsschicht auf die Sensorsegmente mit den gehärteten Fotolackstruktursegmenten der zweiten Fotolackschicht und die horizontal zwischen den Sensorsegmenten gelegenen Zwischenräume;
k) Aufbringen eines zweiten Lösungsmittels, um so die zweite gehärtete Fotolackstruktur und den darauf angeordneten Teil der Funktionsschicht zu entfernen, sodass die Funktionsschicht so strukturiert ist, dass die horizontal zwischen den Sensorsegmenten gelegenen Zwischenräume zumindest teilweise durch die Funktionsschicht ausgefüllt sind; und
l) ganzflächiges Aufbringen einer zweite Elektrodenschicht zum Kontaktieren der organischen Sensorschicht auf die Sensorsegmente und die Funktionsschicht, wobei jedes der Sensorsegmente von der zweiten Elektrodenschicht kontaktiert ist;
wobei wenigstens eine der Elektrodenschichten so strukturiert wird, dass eine Vielzahl von horizontal beabstandeten Elektrodensegmente gebildet wird, so dass jedem der Sensorsegmente wenigstens eines der Elektrodensegmente der jeweiligen Elektrodenschicht zugeordnet ist.

Im Folgenden werden die vorliegende Erfindung und deren Vorteile anhand von Figuren näher beschrieben. Es zeigen:
- Fig. 1: ein erstes Ausführungsbeispiel eines erfindungsgemäßen Sensorbauelements in einer schematischen geschnittenen Seitenansicht;
- Fig. 2: ein zweites Ausführungsbeispiel eines erfindungsgemäßen Sensorbauelements in einer schematischen geschnittenen Seitenansicht;
- Fig. 3: ein drittes Ausführungsbeispiel eines erfindungsgemäßen Sensorbauelements in einer schematischen geschnittenen Seitenansicht;
- Fig. 4: ein viertes Ausführungsbeispiel eines erfindungsgemäßen Sensorbauelements in einer schematischen geschnittenen Seitenansicht;
- Fig. 5: ein fünftes Ausführungsbeispiel eines erfindungsgemäßen Sensorbauelements in einer schematischen geschnittenen Seitenansicht;
- Fig. 6: ein Ersatzschaltbild eines Sensorsegments des fünften Ausführungsbeispiels;
- Fig. 7: ein Diagramm zur Darstellung der spektralen Empfindlichkeit eines Sensorsegments des fünften Ausführungsbeispiels;
- Fig. 8: ein sechstes Ausführungsbeispiel eines erfindungsgemäßen Sensorbauelement in einer schematischen Aufsicht;
- Fig. 9: ein siebtes Ausführungsbeispiel eines erfindungsgemäßen Sensorbauelements in einer schematischen Aufsicht;
- Fig. 10: ein achtes Ausführungsbeispiel eines erfindungsgemäßen Sensorbauelements in einer schematischen Aufsicht;
- Fig. 11: ein neuntes Ausführungsbeispiel eines erfindungsgemäßen Sensorbauelements in einer schematischen Aufsicht;
- Fig. 12: ein zehntes Ausführungsbeispiel eines erfindungsgemäßen Sensorbauelements in einer schematischen geschnittenen Seitenansicht;
- Fig. 13: ein elftes Ausführungsbeispiel eines erfindungsgemäßen Sensorbauelements in einer schematischen geschnittenen Seitenansicht;
- Fig. 14: ein zwölftes Ausführungsbeispiel eines erfindungsgemäßen Sensorbauelements in einer schematischen geschnittenen Seitenansicht;
- Fig. 15: ein dreizehntes Ausführungsbeispiel eines erfindungsgemäßen Sensorbauelements in einer schematischen geschnittenen Seitenansicht;
- Fig. 16a-k: ein Verfahren zum Herstellen eines erfindungsgemäßen Sensorbauelements; und
- Fig. 17a-m: ein weiteres Verfahren zum Herstellen eines erfindungsgemäßen Sensorbauelements.

Gleiche oder gleichartige Elemente oder Elemente mit gleicher oder äquivalenter Funktion sind im Folgenden mit gleichen oder gleichartigen Bezugszeichen versehen.

In der folgenden Beschreibung werden Ausführungsbeispiele mit einer Vielzahl von Merkmalen der vorliegenden Erfindung näher beschrieben, um ein besseres Verständnis der Erfindung zu vermitteln. Es ist jedoch festzuhalten, dass die vorliegende Erfindung auch unter Auslassung einzelner der beschriebenen Merkmale umgesetzt werden kann. Es sei auch darauf hingewiesen, dass die in verschiedenen Ausführungsbeispielen gezeigten Merkmale auch in anderer Weise kombinierbar sind, sofern dies nicht ausdrücklich ausgeschlossen ist oder zu Widersprüchen führen würde.

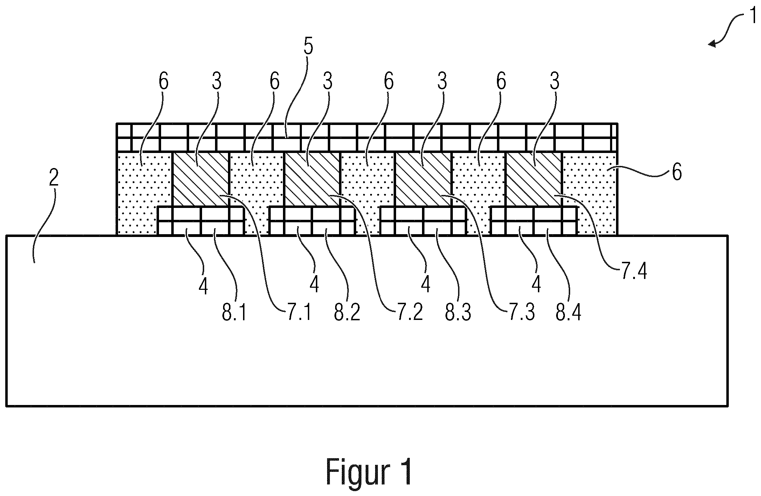

Die Figur 1 zeigt in einer schematischen Seitenansicht ein erstes Ausführungsbeispiel eines erfindungsgemäßen mikrostrukturierten organischen Sensorbauelements, welches folgende parallel zueinander ausgerichteten Schichten umfasst:
eine Substratschicht 2 zum Tragen der weiteren Schichten;
eine organische Sensorschicht 3 zum Umwandeln einer zu erfassenden technischen Größe in eine elektrische Größe;
eine erste Elektrodenschicht 4 zum Kontaktieren der organischen Sensorschicht 3 auf einer der Substratschicht 2 zugewandten Seite der organischen Sensorschicht 3;
eine zweite Elektrodenschicht 5 zum Kontaktieren der organischen Sensorschicht 3 auf einer der Substratschicht 2 abgewandten Seite der organischen Sensorschicht 3; und
eine oder mehrere Funktionsschichten 6;
wobei die Sensorschicht 3 so strukturiert ist, dass eine Vielzahl von horizontal beabstandeten Sensorsegmente 7 gebildet ist;
wobei wenigstens eine der Elektrodenschichten 4, 5 so strukturiert ist, dass eine Vielzahl von horizontal beabstandeten Elektrodensegmente 8 gebildet ist, so dass jedem der Sensorsegmente 7 wenigstens eines der Elektrodensegmente 8 der jeweiligen Elektrodenschicht 4, 5 zugeordnet ist; und
wobei die eine oder mehrere Funktionsschichten 6 horizontal zwischen den Sensorsegmenten 7 gelegene Zwischenräume zumindest teilweise ausfüllen.

Dabei zeigt Figur 1 beispielhaft vier Sensorsegmente 7.1 bis 7.4. In der Praxis kann deren Anzahl jedoch weitaus höher liegen, beispielsweise bei mehreren Millionen. Die erste Elektrodenschicht 4 ist derart strukturiert, dass vier Elektrodensegmente 8.1 bis 8.4 gebildet sind, wobei das Elektrodensegment 8.1 mit dem Sensorsegment 7.1, das Elektrodensegment 8.2 mit dem Sensorsegment 7.2, das Elektrodensegment 8.3 mit dem Sensorsegment 7.3 und das Elektrodensegment 8.4 mit dem Sensorsegment 7.3 elektrisch verbunden ist.

Die zweite Elektrodenschicht 5 ist unstrukturiert und mit allen Elektrodensegmenten 8.1 bis 8.4 elektrisch verbunden.

Gemäß einer bevorzugten Weiterbildung der Erfindung weisen die Sensorsegmente 7 eine maximale horizontale Erstreckung auf, welche kleiner als 50 µm ist.

Gemäß einer zweckmäßigen Weiterbildung der Erfindung umfassen die eine oder mehrere Funktionsschichten 6 eine Passivierungsschicht 6.

Nach einer zweckmäßigen Weiterbildung der Erfindung umfasst die organische Sensorschicht 3 mehrere parallel zu den anderen Schichten angeordnete (in Figur 1 nicht gezeigte) Teilsensorschichten.

Nach einer bevorzugten Weiterbildung der Erfindung sind die Sensorsegmente 7 nach Art einer zweidimensionalen Matrix angeordnet.

Gemäß einer zweckmäßigen Weiterbildung der Erfindung sind die erste und/oder die zweite Elektrodenschicht 4, 5 als organische Schicht, als Metallschicht oder als Metall-Oxid-Multischicht ausgebildet.

Nach einer bevorzugten Weiterbildung der Erfindung ist die Substratschicht 2 als Glasschicht, als Kunststoffschicht oder als Siliziumschicht ausgebildet.

Nach einer zweckmäßigen Weiterbildung der Erfindung sind die Sensorsegmente 7 optische Sensorsegmente 7, sodass das mikrostrukturierte organische Sensorbauelement 1 ein mikrostrukturiertes optisches organisches Sensorbauelement 1 ist.

Gemäß einer bevorzugten Weiterbildung der Erfindung sind die erste und/oder die zweite Elektrodenschicht 4, 5 transparent oder semitransparent.

Nach einer vorteilhaften Weiterbildung der Erfindung ist wenigstens eine der Schichten bei ihrer Herstellung durch Blitzlampenbelichtung getrocknet.

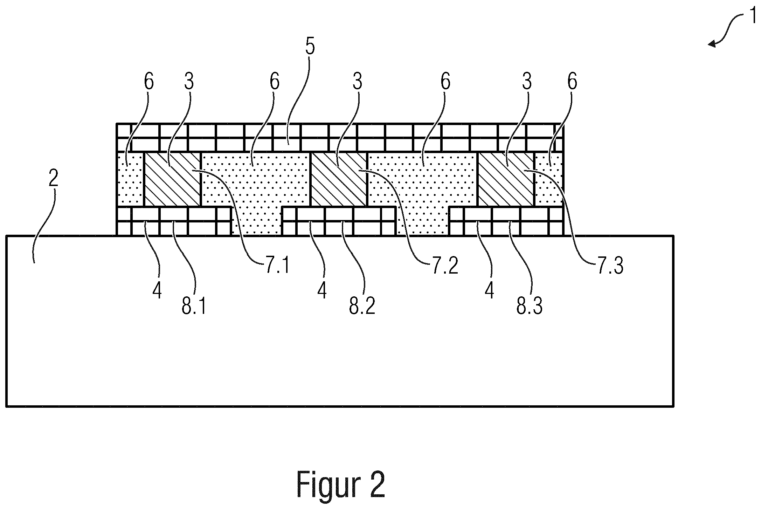

Die Figur 2 zeigt ein zweites Ausführungsbeispiel eines erfindungsgemäßen Sensorbauelements 1 in einer schematischen Seitenansicht. Das Ausführungsbeispiel der Figur 2 beruht auf dem Ausführungsbeispiel der Figur 1, so dass im Folgenden lediglich die Unterschiede beschrieben sind. Dabei zeigt Figur 2 beispielhaft drei Sensorsegmente 7.1 bis 7.3 und eine erste Elektrodenschicht 4 mit drei Elektrodensegmenten 8.1 bis 8.4.

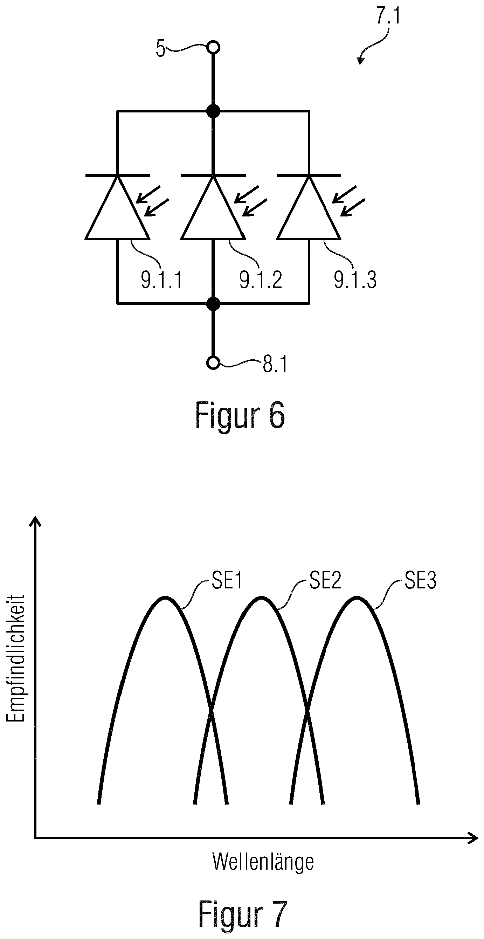

Gemäß einem zweckmäßig ein Ausführungsbeispiel der Erfindung weist eine Gruppe der Sensorsegmente 7 eine spektrale Empfindlichkeit SE (siehe Figur 7) und mindestens eine weitere Gruppe der Sensorsegmente 7 eine jeweils von den spektralen Empfindlichkeiten SE der anderen Gruppen abweichende spektrale Empfindlichkeit SE auf.

So ist im Ausführungsbeispiel der Figur 2 das Sensorsegment 7.1 einer ersten Gruppe mit einer spektralen Empfindlichkeit SE1, das Sensorsegment 7.2 einer zweiten Gruppe mit einer davon abweichenden spektralen Empfindlichkeit SE2 und das Sensorsegment 7.2 einer dritten Gruppe mit einer davon anders abweichenden spektralen Empfindlichkeit SE3 zugehörig.

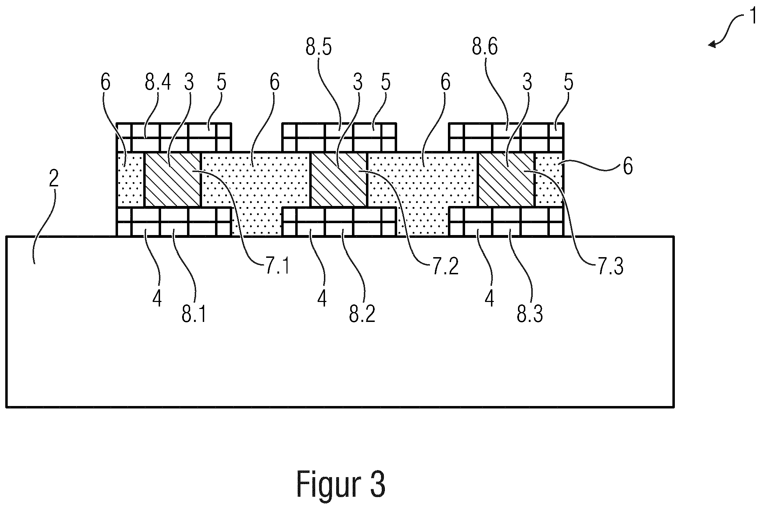

Die Figur 3 zeigt ein drittes Ausführungsbeispiel eines erfindungsgemäßen Sensorbauelements 1 in einer schematischen Seitenansicht. Das Ausführungsbeispiel der Figur 3 beruht auf dem Ausführungsbeispiel der Figur 2, so dass im Folgenden lediglich die Unterschiede beschrieben sind. Im Ausführungsbeispiel der Figur 3 ist nicht nur die erste Elektrodenschicht 4 sondern auch die zweite Elektrodenschicht 5 strukturiert, so dass Letztere Austernelektrodensegmenten 8.4 bis 8.5 besteht.

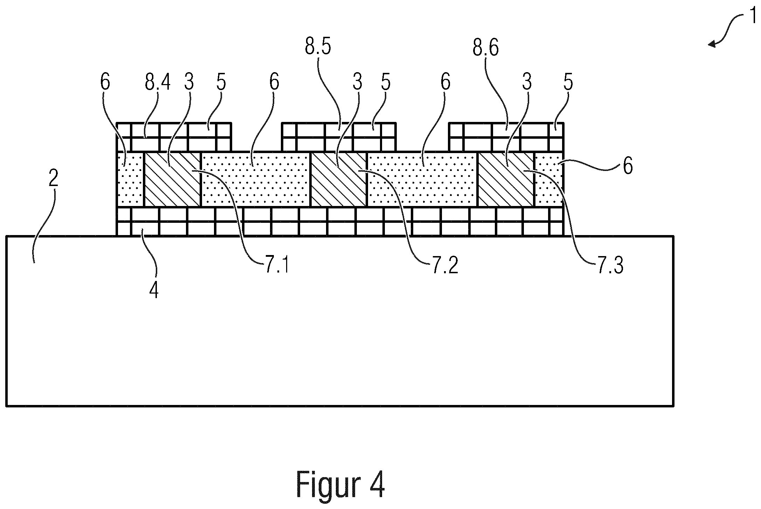

Die Figur 4 zeigt ein viertes Ausführungsbeispiel eines erfindungsgemäßen Sensorbauelements 1 in einer schematischen Seitenansicht.. Das Ausführungsbeispiel der Figur 4 beruht auf dem Ausführungsbeispiel der Figur 3, weshalb im Folgenden lediglich die Unterschiede beschrieben sind. Dabei ist im Ausführungsbeispiel der Figur 4 die erste Elektrodenschicht 4 unstrukturiert, während die zweite Elektrodenschicht 5 wie im Beispiel der Figur 3 strukturiert ist.

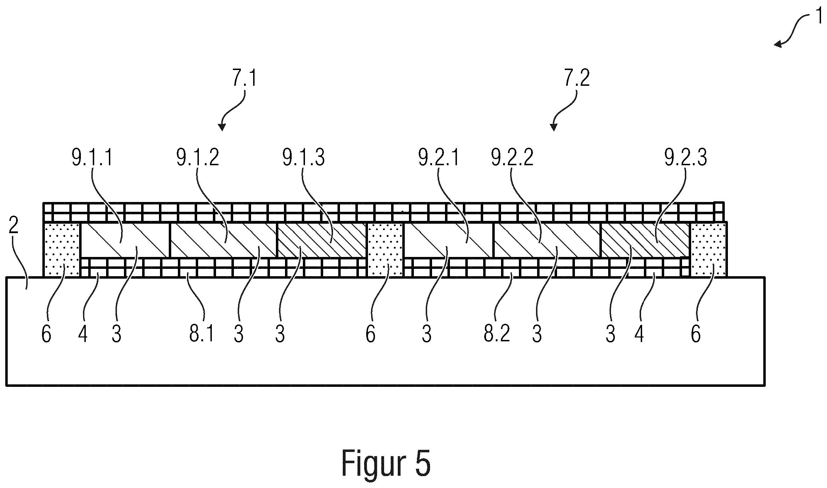

Die Figur 5 zeigt ein fünftes Ausführungsbeispiel eines erfindungsgemäßen Sensorbauelements 1 in einer schematischen Seitenansicht. Dabei beruht das Ausführungsbeispiel der Figur 5 auf dem bisherigen Ausführungsbeispielen. Gezeigt sind beispielhaft zwei Sensorsegmente 7.1 und 7.2 denen jeweils eines der Elektrodensegmente 8.1 und 8.2 der strukturierten ersten Elektrodenschicht 4 zugeordnet ist. Die zweite Elektrodenschicht 5 hingegen ist unstrukturiert ausgeführt.

Gemäß einer vorteilhaften Weiterbildung der Erfindung weisen die Sensorsegmente 7 einen Bereich 9 mit einer spektralen Empfindlichkeit SE und mindestens einen weiteren Bereich 9 mit einer davon abweichenden spektralen Empfindlichkeit SE auf.

So weist im Ausführungsbeispiel der Figur 5 das Sensorsegment 7.1 einen ersten Bereich 9.1 1 mit einer spektralen Empfindlichkeit SE1 (siehe Figur 7), einen zweiten Bereich 9.1.2 mit einer davon abweichenden spektralen Empfindlichkeit SE2 und einen dritten Bereich 9.1.3 mit einer davon anders abweichenden spektralen Empfindlichkeit SE3 auf. Analog weist das Sensorsegment 7.2 einen ersten Bereich 9.2 1 mit einer spektralen Empfindlichkeit SE1, einen zweiten Bereich 9.2.2 mit einer davon abweichenden spektralen Empfindlichkeit SE2 und einen dritten Bereich 9.2.3 mit einer davon anders abweichenden spektralen Empfindlichkeit SE3 auf.

Die Figur 6 zeigt ein Ersatzschaltbild eines Sensorsegments 7.1 des fünften Ausführungsbeispiels. Der erste Bereich 9.1.1 ist dabei als erste Fotodiode 9.1.1, der zweite Bereich 9.1.2 als zweite Fotodiode 9.1.2 und der dritte Bereich 9.1.3 als dritte Fotodiode 9.1.3 dargestellt. Die Photodioden 9.1.1 bis 9.1.3 sind dabei parallel geschaltet mit der zweiten Elektrodenschicht 5 und dem Elektrodensegment 8.1 der ersten Elektrodenschicht 4 verbunden.

Die Figur 7 zeigt ein Diagramm zur Darstellung der spektralen Empfindlichkeit SE eines Sensorsegments 7 des fünften Ausführungsbeispiels. Unter der spektralen Empfindlichkeit SE versteht man die Abhängigkeit der Empfindlichkeit des Sensorsegments SE in Abhängigkeit von der Wellenlänge der zu detektierenden Strahlung. Wie bereits ausgeführt, weist im Ausführungsbeispiel der Figur 5 das Sensorsegment 7.1 einen ersten Bereich 9.1 1 mit einer spektralen Empfindlichkeit SE1, einen zweiten Bereich 9.1.2 mit einer davon abweichenden spektralen Empfindlichkeit SE2 und einen dritten Bereich 9.1.3 mit einer davon anders abweichenden spektralen Empfindlichkeit SE3 auf. Analog weist das Sensorsegment 7.2 einen ersten Bereich 9.2 1 mit einer spektralen Empfindlichkeit SE1, einen zweiten Bereich 9.2.2 mit einer davon abweichenden spektralen Empfindlichkeit SE2 und einen dritten Bereich 9.2.3 mit einer davon anders abweichenden spektralen Empfindlichkeit SE3 auf. Die gesamte spektrale Empfindlichkeit SE des Sensorsegments 7.1 ergibt sich durch die Addition der spektralen Empfindlichkeiten SE 1 bis SE3, so dass das Sensorsegment 7.1 sehr breitbandig ist.

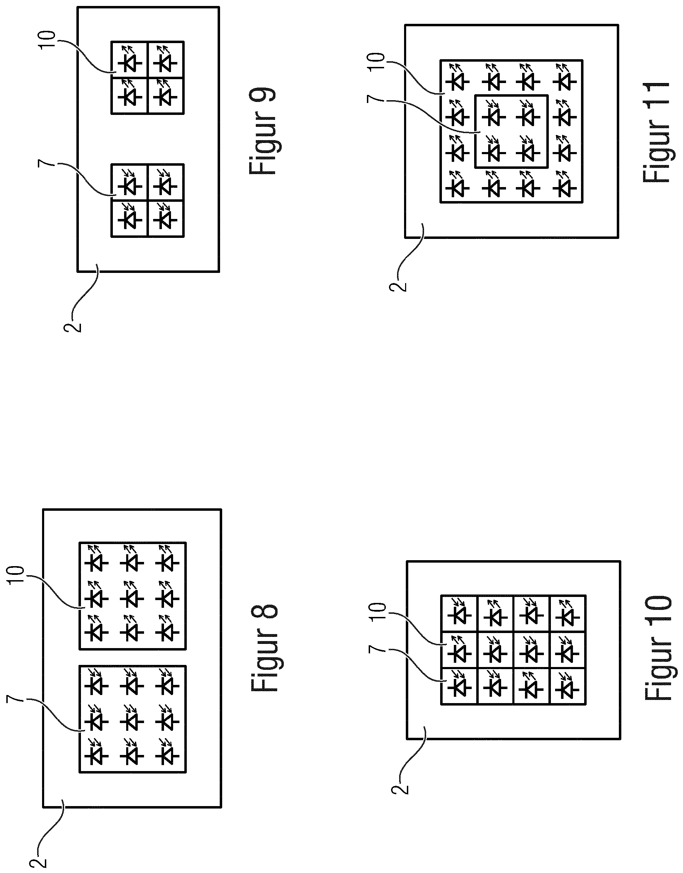

Die Figuren 8 bis 11 zeigen unterschiedliche Ausführungsbeispiele eines erfindungsgemäßen Sensorbauelement 1 gemäß zweckmäßiger Weiterbildungen der Erfindung, wobei jeweils auf der Substratschicht 2 eine oder mehrere Leuchtdioden 10 ausgebildet sind.

Die Figur 8 zeigt ein sechstes Ausführungsbeispiel eines erfindungsgemäßen Sensorbauelements 1 in einer schematischen Aufsicht. Im Ausführungsbeispiel der Figur 8 sind sowohl die Photodioden 7 als auch die Leuchtdioden 10 in 3 × 3 Matrizen angeordnet. Dabei wechseln sich jeweils aus Photodioden 7 bestehende Matrizen und aus Leuchtdioden 10 bestehende Matrizen ab, wobei aus Platzgründen jeweils nur eine aus Photodioden 7 bestehende Matrix und nur eine aus Leuchtdioden 10 bestehende Matrix gezeigt ist.

Die Figur 9 zeigt ein siebtes Ausführungsbeispiel eines erfindungsgemäßen Sensorbauelements 1 in einer schematischen Aufsicht. Das Ausführungsbeispiel der Figur 9 beruht auf dem Ausführungsbeispiel der Figur 8, wobei allerdings die Photodioden 7 und auch die Leuchtdioden 10 in 2 × 2 Matrizen angeordnet sind.

Die Figur 10 zeigt ein achtes Ausführungsbeispiel eines erfindungsgemäßen Sensorbauelements 1 in einer schematischen Aufsicht. Hierbei sind die Photodioden 7 und die Leuchtdioden 10 in einer gemeinsamen Matrix jeweils abwechselnd angeordnet. Gezeigt ist dabei eine gemeinsame 4 x 4 Matrix. Es versteht sich von selbst, dass das die Matrix auch größer sein könnte oder dass auch mehrere derartige Matrizen vorgesehen sein könnten.

Die Figur 11 zeigt ein neuntes Ausführungsbeispiel eines erfindungsgemäßen Sensorbauelements 1 in einer schematischen Aufsicht. Dabei sind die Photodioden 7 und die Leuchtdioden 10 in einer gemeinsamen Matrix so angeordnet, dass die Photodioden 7 in einem inneren Bereich der gemeinsamen Matrix und die Leuchtdioden 10 in einem äußeren Bereich der gemeinsamen Matrix angeordnet sind. Auch hier ist beispielhaft eine gemeinsame 4 × 4 Matrix gezeigt, wobei auch größere Matrizen oder eine Vielzahl von Matrizen vorgesehen sein könnten.

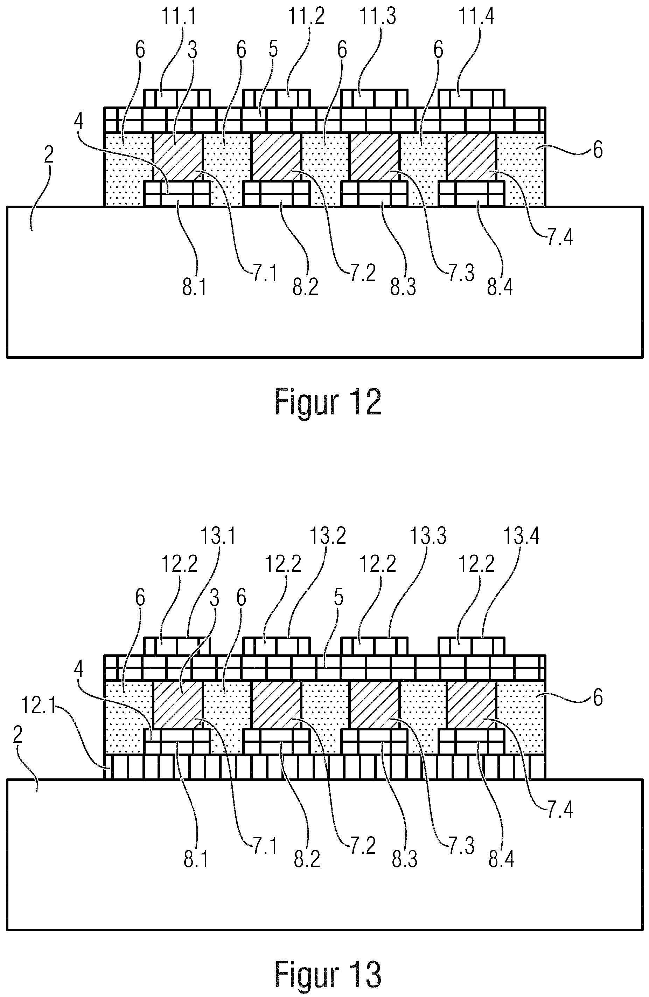

Die Figur 12 zeigt ein zehntes Ausführungsbeispiel eines erfindungsgemäßen Sensorbauelements 1 in einer schematischen Seitenansicht. Das Ausführungsbeispiel der Figur 12 beruht auf dem Ausführungsbeispiel der Figur 1, weswegen im Folgenden nur auf die Unterschiede eingegangen wird.

Gemäß einer zweckmäßigen Weiterbildung der Erfindung umfassen die Schichten eine oder mehrere Lichtkoppelschichten 11, welche zum Verbessern der Lichtkoppeleffizienz beim Einkoppeln von Licht in eine der Elektrodenschichten 4, 5 und/oder beim Auskoppeln von Licht aus einer der Elektrodenschichten 4, 5 ausgebildet sind, wobei auf der der organischen Sensorschicht 3 abgewandten Seite der ersten Elektrodenschicht 4 und/oder auf der der organische Sensorschicht 3 abgewandten Seite der zweite Elektrodenschicht 5 jeweils eine der Lichtkoppelschichten 11 vorgesehen ist.

Dabei ist im Ausführungsbeispiel der Figur 12 lediglich eine Lichtkuppelschicht 11 an der zweiten Elektrodenschicht 5 vorgesehen. Es könnte jedoch auch alternativ oder zusätzlich eine Lichtkuppelschicht 11 an der ersten Elektrodenschicht 4 vorgesehen sein. Die Lichtkuppelschicht 11 umfasst Segmente 11.1 bis 11.4, wobei jedes dieser Segmente 11.1 bis 11.4 genau einem der Sensorsegmente 7.1 bis 7.4 zugeordnet ist. Die Lichtkuppelschicht 11 könnte jedoch auch ganzflächig ausgebildet sein.

Die Figur 13 zeigt ein elftes Ausführungsbeispiel eines erfindungsgemäßen Sensorbauelements 1 in einer schematischen Seitenansicht. Das Ausführungsbeispiel der Figur 12 beruht ebenfalls auf dem Ausführungsbeispiel der Figur 1, weswegen im Folgenden nur auf die Unterschiede eingegangen wird.

Gemäß einer bevorzugten Weiterbildung der Erfindung umfassen die Schichten eine oder mehrere Filterschichten 12, welche zum spektralen Filtern von Licht beim Einkoppeln von Licht in eine der Elektrodenschichten 4, 5 und/oder beim Auskoppeln von Licht aus einer der Elektrodenschichten ausgebildet sind, wobei auf der der organischen Sensorschicht 3 abgewandten Seite der ersten Elektrodenschicht 4 und/oder auf der der organischen Sensorschicht 3 abgewandten Seite der zweite Elektrodenschicht 5 jeweils eine der Filterschichten 12 vorgesehen ist.

Im Ausführungsbeispiel der Figur 13 ist an der ersten Elektrodenschicht 4 eine Filterschicht 12.1 und an der zweiten Elektrodenschicht 5 eine Filter Schicht 12.2 vorgesehen. Es sind aber auch Ausführungsbeispiele denkbar, bei denen nur eine der Filterschichten 12.1 bzw. 12. 2 vorhanden ist.

Gemäß einer bevorzugten Weiterbildung der Erfindung sind die eine oder mehreren Filterschichten 12 so strukturiert, dass eine Vielzahl von horizontal nebeneinander liegenden Filtersegmenten 13 gebildet ist, so dass jedem der Sensorsegmente 7 wenigstens eines der Filtersegmente 13 der jeweiligen Filterschicht 12 zugeordnet ist, wobei eine erste Gruppe der Filtersegmente 13 der jeweiligen Filterschicht 12 eine erste spektrale Charakteristik und eine zweite Gruppe der Filtersegmente 13 der jeweiligen Filterschicht 12 eine von der zweiten spektralen Charakteristik abweichende zweite spektrale Charakteristik aufweist.

Im Ausführungsbeispiel der Figur 13 ist die Filterschicht 12.2 strukturiert, so dass Filtersegmente 13.1 bis 13.4 gebildet sind. Dabei können die Filtersegmente 13.1 bis 13.4 unterschiedlichen Gruppen von Filtersegmenten zugeordnet sein, welche unterschiedliche spektrale Charakteristika aufweisen. Demgegenüber ist die Filterschicht 12.1 ganzflächig ausgeführt.

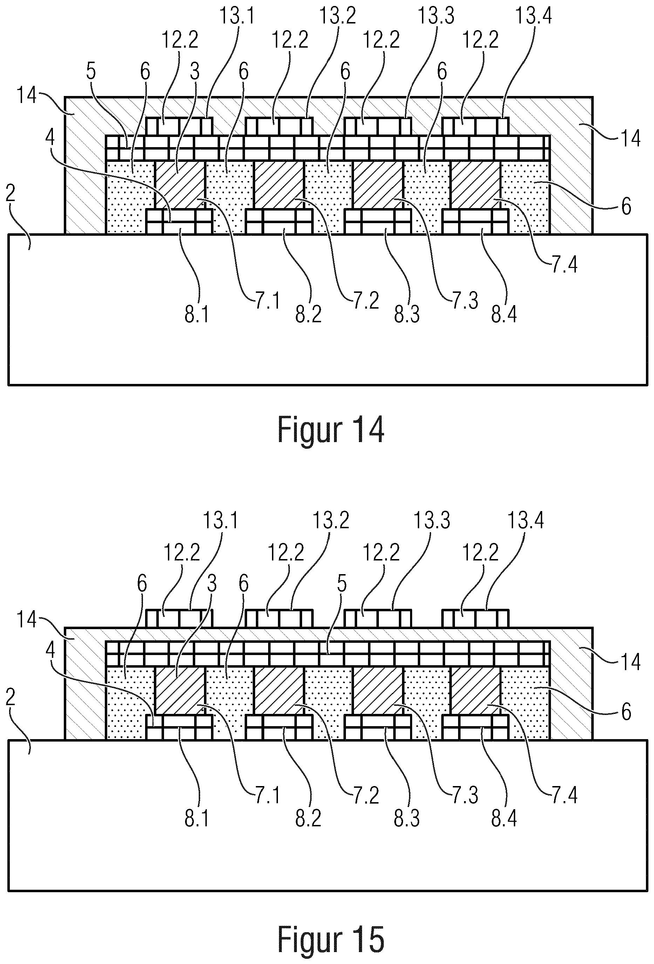

Die Figur 14 zeigt ein zwölftes Ausführungsbeispiel eines erfindungsgemäßen Sensorbauelements 1 in einer schematischen Seitenansicht. Das Ausführungsbeispiel der Figur 14 beruht auf dem Ausführungsbeispiel der Figur 13, weswegen im Folgenden nur auf die Unterschiede eingegangen wird.

Gemäß einer vorteilhaften Weiterbildung der Erfindung ist eine Dünnschichtverkapselung 14 zum Schutz wenigstens eines Teiles der Schichten vor der Einwirkung von Feuchtigkeit vorgesehen.

Im Ausführungsbeispiel der Figur 14 umschließt die Dünnschichtverkapselung 14 im Zusammenwirken mit der Substratschicht 2 sämtliche auf der Substratschicht 2 angeordneten Schichten.

Nach einer vorteilhaften Weiterbildung der Erfindung ist, wie in Figur 14 gezeigt, die Dünnschichtverkapselung 14 zur Verhinderung eines horizontalen Eindringens von Flüssigkeit zwischen zumindest einige der Schichten ausgebildet.

Die Figur 15 zeigt ein dreizehntes Ausführungsbeispiel eines erfindungsgemäßen Sensorbauelements 1 in einer schematischen Seitenansicht. Das Ausführungsbeispiel der Figur 15 beruht auf dem Ausführungsbeispiel der Figur 14, weswegen im Folgenden nur auf die Unterschiede eingegangen wird.

Abweichend von Figur 14 ist hier die Filterschicht 12.2 auf der Außenseite der Dünnschichtverkapselung 14 angeordnet.

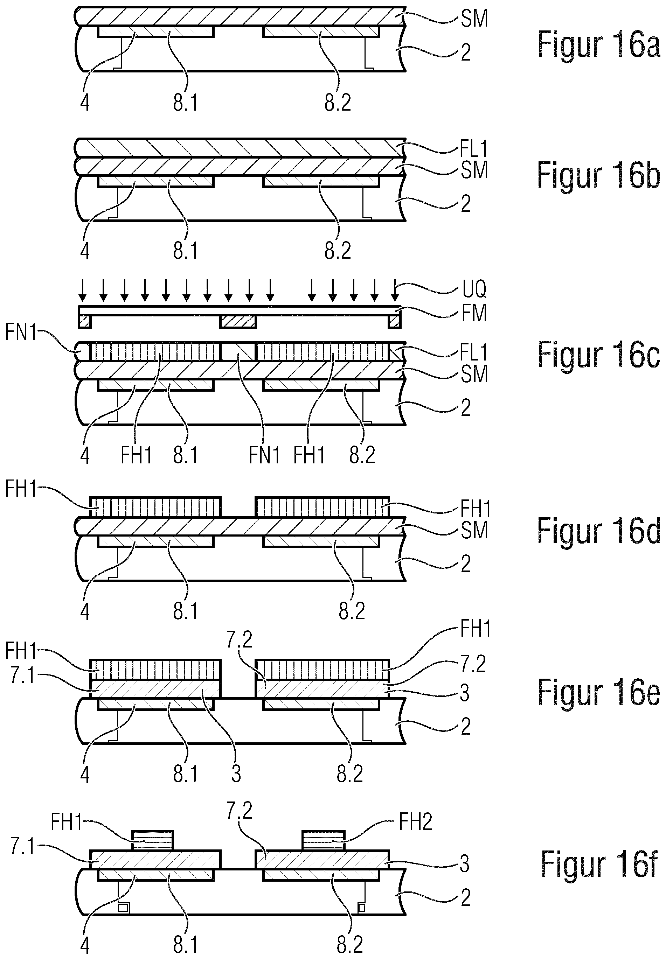

Die Figuren 16a-k zeigen ein Verfahren zur Herstellung eines mikrostrukturierten organischen Sensorbauelements 1 mit parallel zueinander ausgerichteten Schichten, wobei die Schichten eine Sensorschicht 3 umfassen, welche so strukturiert ist, dass eine Vielzahl horizontal beabstandeten Sensorsegmente 7 gebildet ist, wobei jedes Sensorsegment 7 aus einem oder mehreren Bereichen 9 besteht, insbesondere nach einem der Ansprüche 1-20, wobei das Verfahren folgende Schritte in folgender Reihenfolge umfasst:
a) Bereitstellen einer Substratschicht 2 zum Tragen der weiteren Schichten, wobei an der Substratschicht 2 eine erste Elektrodenschicht 4 zum Kontaktieren einer organischen Sensorschicht 3 zum Umwandeln einer zu erfassenden technischen Größe in eine elektrische Größe angeordnet ist;
b) ganzflächiges Aufbringen mindestens einer organischen Sensormaterialschicht SM auf einen Verbund aus der Substratschicht 2 und der erste Elektrodenschicht 4;
c) ganzflächiges Aufbringen einer ersten Fotolackschicht FL1 auf die organische Sensormaterialschicht SM;
d) selektives Belichten der ersten Fotolackschicht FL1, so dass eine erste gehärtete Fotolackstruktur FH1 mit horizontal beabstandeten ersten gehärteten Fotolackstruktursegmenten FH1 und eine erste nicht gehärtete Fotolackstruktur FN1 entstehen;
e) Entfernen der ersten nicht gehärteten Fotolackstruktur FN1 mittels eines ersten Entwicklungslösungsmittels;
f) Aufbringen eines ersten Lösungsmittels, um so einen nicht von der ersten gehärteten Fotolackstruktur FH1 bedeckten Teil der mindestens einen organischen Sensormaterialschicht SM zu entfernen, sodass durch einen verbleibenden Teil der mindestens einen organischen Sensormaterialschicht SM jeweils wenigstens einer der Bereiche 9 der Sensorsegmente 7 der Sensorschicht 3 gebildet wird, sodass jedes der Sensorsegmente 7 von der ersten Elektrodenschicht 4 kontaktiert ist;
g) Entfernen der ersten gehärteten Fotolackstruktur FH1 mittels eines zweiten Lösungsmittels;
h) ganzflächiges Aufbringen einer zweiten Fotolackschicht auf die Sensorsegmente 7 und auf horizontal zwischen den Sensorsegmenten 7 gelegene Zwischenräume;
i) selektive Belichtung der zweiten Fotolackschicht, so dass eine zweite gehärtete Fotolackstruktur FH2 mit horizontal beabstandeten zweiten gehärteten Fotolackstruktursegmenten FH2 und eine zweite nicht gehärtete Fotolackstruktur entstehen, wobei an jedem Sensorsegment 7 wenigstens eines der zweiten gehärteten Fotolackstruktursegmente FH2 ausgebildet ist;
j) Entfernen der zweiten nicht gehärteten Fotolackstruktur mittels eines zweiten Entwicklungslösungsmittels;
k) ganzflächiges Aufbringen einer Funktionsschicht 6 auf die Sensorsegmente 7 mit den zweiten gehärteten Fotolackstruktursegmenten FH2 und die horizontal zwischen den Sensorsegmenten 7 gelegenen Zwischenräume;
l) ganzflächiges Aufbringen einer dritten Fotolackschicht auf die Funktionsschicht 6;
m) selektive Belichtung der dritten Fotolackschicht, so dass eine dritte gehärtete Fotolackstruktur FH3 und eine dritte nicht gehärtete Fotolackstruktur mit horizontal beabstandeten nicht gehärteten Fotolackstruktursegmenten entstehen, wobei jedem der zweiten gehärteten Fotolackstruktursegmente FH2 eines der nicht gehärteten Fotolackstruktursegmente der dritten Fotolackschicht zugeordnet ist;
n) Entfernen der dritten nicht gehärteten Fotolackstruktur mittels eines dritten Entwicklungslösungsmittels;
o) Aufbringen eines dritten Lösungsmittels, um so einen nicht von der dritten gehärteten Fotolackstruktur FH3 bedeckten Teil der Funktionsschicht 6 und die zweiten gehärteten Fotolackstruktursegmente FH2 zu entfernen, sodass die Funktionsschicht 6 so strukturiert ist, dass die horizontal zwischen den Sensorsegmenten 7 gelegenen Zwischenräume zumindest teilweise durch die Funktionsschicht 6 ausgefüllt sind;
p) Entfernen der dritten gehärteten Fotolackstruktur FH3 mittels eines vierten Lösungsmittels; und
q) ganzflächiges Aufbringen einer zweite Elektrodenschicht 5 zum Kontaktieren der organischen Sensorschicht 3 auf die Sensorsegmente 7 und die Funktionsschicht 6, sodass jedes der Sensorsegmente 7 von der zweiten Elektrodenschicht 5 kontaktiert ist;
wobei wenigstens eine der Elektrodenschichten 4, 5 so strukturiert wird, dass eine Vielzahl von horizontal beabstandeten Elektrodensegmente 8 gebildet wird, so dass jedem der Sensorsegmente 7 wenigstens eines der Elektrodensegmente 8 der jeweiligen Elektrodenschicht 4, 5 zugeordnet ist.

Die in Schritt a) bereitgestellte Substratschicht 2 kann ein Wafer mit integrierter CMOS-Ausleseelektronik sein. In Schritt b) kann die organische Sensormaterialschicht SM durch auf Schleudern, Schlitzdüsenbeauftragung oder durch aufsprühen aufgebracht werden. Das Ergebnis des Schritts b) ist in Figur 16a dargestellt.

Figur 16b zeigt das Ergebnis des Schritts c). Weiterhin veranschaulicht Figur 16c die Durchführung des Schritts d). Figur 16d zeigt Schritt e), bei dem mittels eines Ätzprozesses ein Teil des ersten Fotolacks FL1, nämlich die erste nicht gehärtete Fotolackstruktur FN1 entfernt wird. Danach wird, wie in Figur 16e gezeigt, gemäß Schritt f) ein Teil der Sensormaterialschicht SM entfernt, so dass zumindest ein Teil der Sensorschicht 3, beispielsweise die voneinander horizontal beanstandeten Sensorsegmente 7.1 und 7.2 oder jeweils ein Bereich 9 der Sensorsegmente 7.1 und 7.2, entstehen. Die Schritte b) bis f) können ggf. mehrfach durchgeführt werden, um Sensorsegmente 7.1 und 7.2 herzustellen, welche jeweils mehrere Bereiche 9 aus unterschiedlichen Sensormaterialien umfassen. Die Schritte b) bis f) können auch mehrfach durchgeführt werden, wenn Sensorsegmente 7 mit mehreren Bereichen 9 aus unterschiedlichen Sensormaterialien hergestellt werden sollen.

Dann kann gemäß Schritt g) die erste gehärtete Fotolackstruktur FH1 mittels eines zweiten Lösungsmittels entfernt werden.

Weiterhin kann gemäß Schritt h) ein ganzflächiges Aufbringen einer zweiten Fotolackschicht auf die Sensorsegmente 7 und auf horizontal zwischen den Sensorsegmenten 7 gelegene Zwischenräume erfolgen sowie gemäß Schritt i) eine selektive Belichtung der zweiten Fotolackschicht durchgeführt werden, so dass eine zweite gehärtete Fotolackstruktur FH2 mit horizontal beabstandeten gehärteten Fotolackstruktursegmenten FH2 und eine zweite nicht gehärtete Fotolackstruktur entsteht, wobei an jedem Sensorsegment 7 wenigstens ein gehärtetes Fotolackstruktursegment FH2 ausgebildet ist. Das Ergebnis dieser Schritte ist in Figur 16f dargestellt.

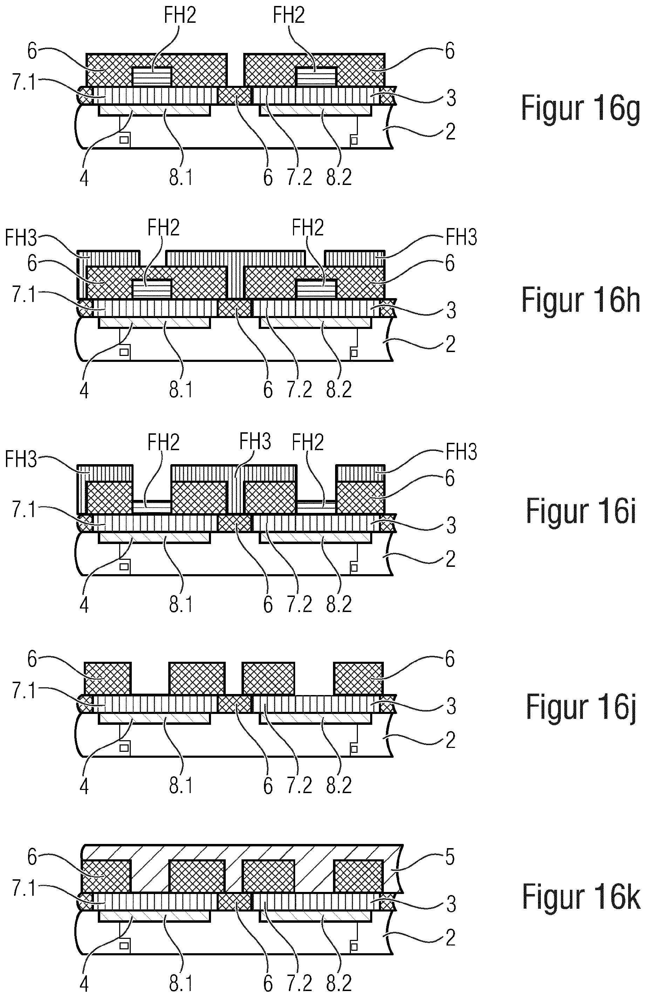

Darunter kann gemäß Schritt k) ein ganzflächiges Aufbringen einer Funktionsschicht 6 auf die Sensorsegmente 7, die zweiten gehärteten Fotolackstruktursegmente FH2 und die horizontal zwischen den Sensorsegmenten 7 gelegene Zwischenräume erfolgen, was in Figur 16g dargestellt ist. Dabei können die Seiten, die Kanten und oder Teile der Oberseite der Sensorsegmente 7.1 und 7.2 durch die Funktionsschicht 6 bedeckt werden. Die Funktionsschicht 6 kann als Reflexions- oder Absorptionsschicht dienen.

In Figur 16h ist das Ergebnis der Schritte l) ganzflächiges Aufbringen einer dritten Fotolackschicht auf die Funktionsschicht 6, m) selektive Belichtung der dritten Fotolackschicht, so dass eine dritte gehärtete Fotolackstruktur FH3 und eine dritte nicht gehärtete Fotolackstruktur mit horizontal beabstandeten nicht gehärteten Fotolackstruktursegmenten FH3 entsteht, wobei jedem der zweiten gehärteten Fotolackstruktursegmente FH2 eines der dritten nicht gehärteten Fotolackstruktursegmente FH3 zugeordnet ist und n) Entfernen der dritten nicht gehärteten Fotolackstruktur mittels eines dritten Entwicklungslösungsmittels dargestellt.

Die Figur 16i zeigt das Ergebnis des Schrittes o) Aufbringen eines dritten Lösungsmittels, um so einen nicht von der dritten gehärteten Fotolackstruktur FH3 bedeckten Teil der Funktionsschicht 6 und die zweiten gehärteten Fotolackstruktursegmente FH2 zu entfernen, sodass die Funktionsschicht 6 so strukturiert ist, dass die horizontal zwischen den Sensorsegmenten 7 gelegenen Zwischenräume zumindest teilweise ausgefüllt sind.

Weiterhin zeigt die Figur 16j das Ergebnis des Schrittes p) Entfernen der dritten gehärteten Fotolackstruktur FH3 mittels eines vierten Lösungsmittels.

Darüber hinaus zeigt die Figur 16k das Ergebnis des Schrittes q) ganzflächiges Aufbringen einer zweite Elektrodenschicht 5 zum Kontaktieren der organischen Sensorschicht 3 auf die Sensorsegmente 7 und die Funktionsschicht 6, wobei jedes der Sensorsegmente 7 von der zweiten Elektrodenschicht 5 kontaktiert ist.

Die Schritte a) bis q) werden dabei so durchgeführt, dass wenigstens eine der Elektrodenschichten 4, 5 so strukturiert wird, dass eine Vielzahl von horizontal beabstandeten Elektrodensegmenten 8 gebildet wird, so dass jedem der Sensorsegmente 7 wenigstens eines der Elektrodensegmente 8 der jeweiligen Elektrodenschicht 4, 5 zugeordnet ist und dass die Sensorschicht 3 so strukturiert wird, dass eine Vielzahl von horizontal beabstandeten Sensorsegmenten 7 gebildet ist und dass jedes der Sensorsegmente 7 von der ersten Elektrodenschicht 4 kontaktiert ist.

Nun könnte eine Abscheidung von Farbfilterschichten und/oder einer Dünnschichtverkapselung auf die Sensorsegmente erfolgen, wobei sich die Reihenfolge je nach Farbfiltermaterial- und Abscheideprozess richten kann.

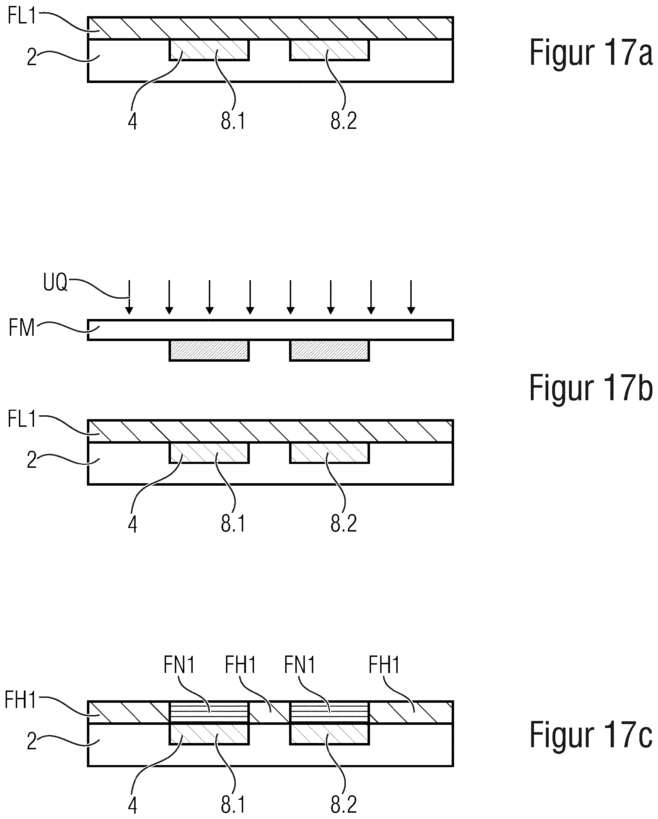

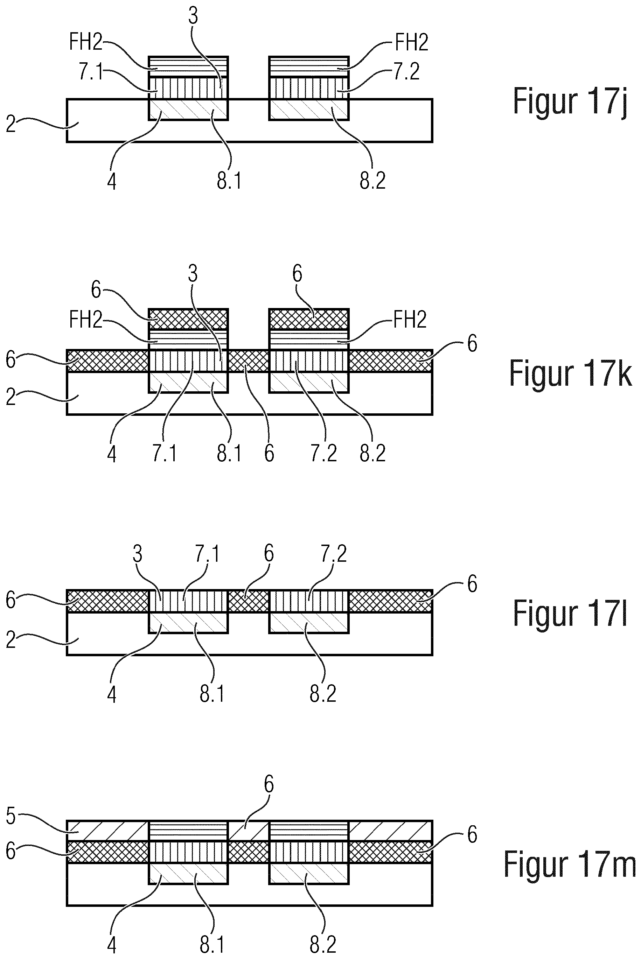

Die Figuren 17a-m zeigen ein weiteres Verfahren zur Herstellung eines mikrostrukturierten organischen Sensorbauelements 1 mit parallel zueinander ausgerichteten Schichten, wobei die Schichten eine Sensorschicht 3 umfassen, welche so strukturiert ist, dass eine Vielzahl horizontal beabstandeten Sensorsegmente 7 gebildet ist, wobei jedes Sensorsegment 7 aus einem oder mehreren Bereichen 9 besteht, insbesondere nach einem der Ansprüche 1-20, wobei das Verfahren folgende Schritte in folgender Reihenfolge umfasst:
a) Bereitstellen einer Substratschicht 2 zum Tragen der weiteren Schichten, wobei an der Substratschicht 2 eine erste Elektrodenschicht 4 zum Kontaktieren einer organischen Sensorschicht 3 zum Umwandeln einer zu erfassenden technischen Größe in eine elektrische Größe angeordnet ist;
b) ganzflächiges Aufbringen einer ersten Fotolackschicht FL1 auf einen Verbund aus der Substratschicht 2 und der ersten Elektrodenschicht 4;
c) selektives Belichten der ersten Fotolackschicht FL1, so dass eine erste gehärtete Fotolackstruktur FH1 und eine erste nicht gehärtete Fotolackstruktur FN1 mit ersten horizontal beabstandeten gehärteten Fotolackstruktursegmenten FN1 entstehen;
d) Entfernen der ersten nicht gehärteten Fotolackstruktur FN1 mittels eines ersten Entwicklungslösungsmittels;
e) ganzflächiges Aufbringen einer organischen Sensormaterialschicht SM auf einen Verbund aus der Substratschicht 2, der ersten Elektrodenschicht 4 und der ersten gehärteten Fotolackstruktur FH1;
f) Aufbringen eines ersten Lösungsmittels, um so die erste gehärtete Fotolackstruktur FH1 und den darauf angeordneten Teil der organischen Sensormaterialschicht SM zu entfernen, sodass durch einen verbleibenden Teil der mindestens einen organischen Sensormaterialschicht SM jeweils wenigstens einer der Bereiche 9 der Sensorsegmente 7 der Sensorschicht 3 gebildet wird, sodass jedes der Sensorsegmente 7 von der ersten Elektrodenschicht 4 kontaktiert ist;
g) ganzflächiges Aufbringen einer zweiten Fotolackschicht FL2 auf einen Verbund aus der Substratschicht 2, der ersten Elektrodenschicht 4 und den Sensorsegmenten 7;
h) selektives Belichten der zweiten Fotolackschicht FL2, so dass eine zweite gehärtete Fotolackstruktur FH2 mit zweiten horizontal beabstandeten gehärteten Fotolackstruktursegmenten FH2 und eine zweite nicht gehärtete Fotolackstruktur FN2 entstehen, wobei an jedem Sensorsegment 7 wenigstens ein gehärtetes Fotolackstruktursegment FH2 der zweiten Fotolackschicht FL2 ausgebildet ist;
i) Entfernen der zweiten nicht gehärteten Fotolackstruktur FN2 mittels eines zweiten Entwicklungslösungsmittels;
j) ganzflächiges Aufbringen einer Funktionsschicht 6 auf die Sensorsegmente 7 mit den gehärteten Fotolackstruktursegmenten FH2 der zweiten Fotolackschicht FL2 und die horizontal zwischen den Sensorsegmenten 7 gelegenen Zwischenräume;
k) Aufbringen eines zweiten Lösungsmittels, um so die zweite gehärtete Fotolackstruktur FH2 und den darauf angeordneten Teil der Funktionsschicht 6 zu entfernen, sodass die Funktionsschicht 6 so strukturiert ist, dass die horizontal zwischen den Sensorsegmenten 7 gelegenen Zwischenräume zumindest teilweise durch die Funktionsschicht 6 ausgefüllt sind; und
l) ganzflächiges Aufbringen einer zweite Elektrodenschicht 5 zum Kontaktieren der organischen Sensorschicht 3 auf die Sensorsegmente 7 und die Funktionsschicht 6, wobei jedes der Sensorsegmente 7 von der zweiten Elektrodenschicht 5 kontaktiert ist;
wobei wenigstens eine der Elektrodenschichten 4, 5 so strukturiert wird, dass eine Vielzahl von horizontal beabstandeten Elektrodensegmente 8 gebildet wird, so dass jedem der Sensorsegmente 7 wenigstens eines der Elektrodensegmente 8 der jeweiligen Elektrodenschicht 4, 5 zugeordnet ist.

Die in Schritt a) bereitgestellte Substratschicht 2 kann ein Wafer mit integrierter CMOS-Ausleseelektronik sein. In Schritt b) kann die erste Fotolackschicht FL1 auf den Verbund aus der Substratschicht 2 und der ersten Elektrodenschicht 4 aufgetragen werden. Das Ergebnis des Schritts b) ist in Figur 17a dargestellt.

Das Belichten der ersten Fotolackschicht FL1 gemäß Schritt c) ist in Figur 17b gezeigt, wobei die entstehende erste gehärtete Fotolackstruktur FH1 und die entstehende erste nicht gehärtete Fotolackstruktur FN1 mit den horizontal beabstandeten gehärteten Fotolackstruktursegmenten FN1 in Figur 17c gezeigt sind.

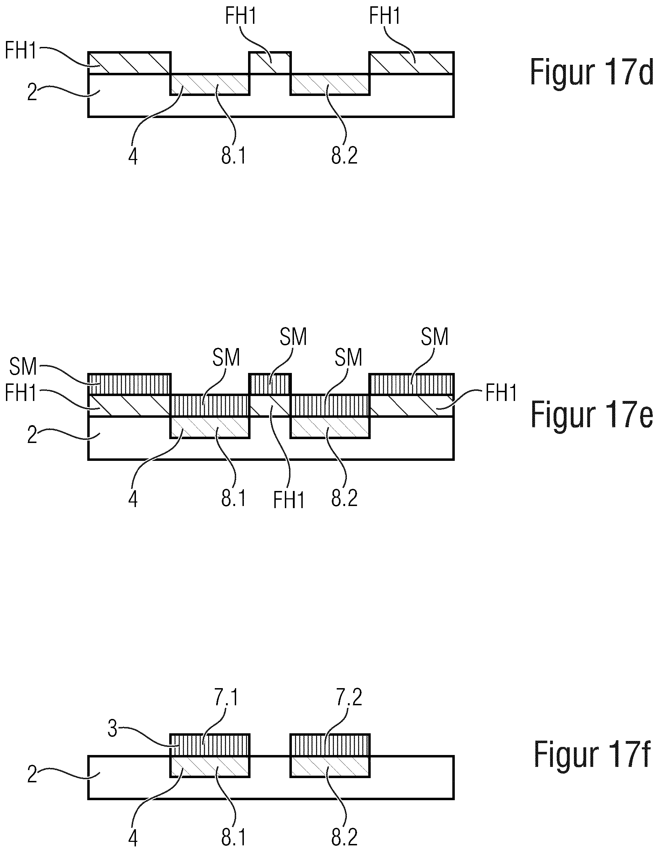

Weiterhin illustriert Figur 17d das Entfernen der ersten nicht gehärteten Fotolackstruktur FN1 gemäß Schritt d). Das ganzflächige Aufbringen einer organischen Sensormaterialschicht SM auf einen Verbund aus der Substratschicht 2, der ersten Elektrodenschicht 4 und der ersten gehärteten Fotolackstruktur FH1 gemäß Schritt e) ist dann in Figur 17e dargestellt.

In Figur 17f ist dargestellt, wie gemäß Schritt f) nach dem Aufbringen eines ersten Lösungsmittels die erste gehärtete Fotolackstruktur FH1 und den darauf angeordneten Teil der organischen Sensormaterialschicht SM entfernt sind, sodass durch einen verbleibenden Teil der mindestens einen organischen Sensormaterialschicht SM jeweils wenigstens einer der Bereiche 9 der Sensorsegmente 7 der Sensorschicht 3 gebildet wird, wobei jedes der Sensorsegmente 7 von der ersten Elektrodenschicht 4 kontaktiert ist. Ein derartiger Schritt, bei dem durch ein Lösungsmittel eine tiefer liegende Schicht gelöst wird um eine höher liegende Schicht abzulösen, wird auch Lift-off Schritt genannt.

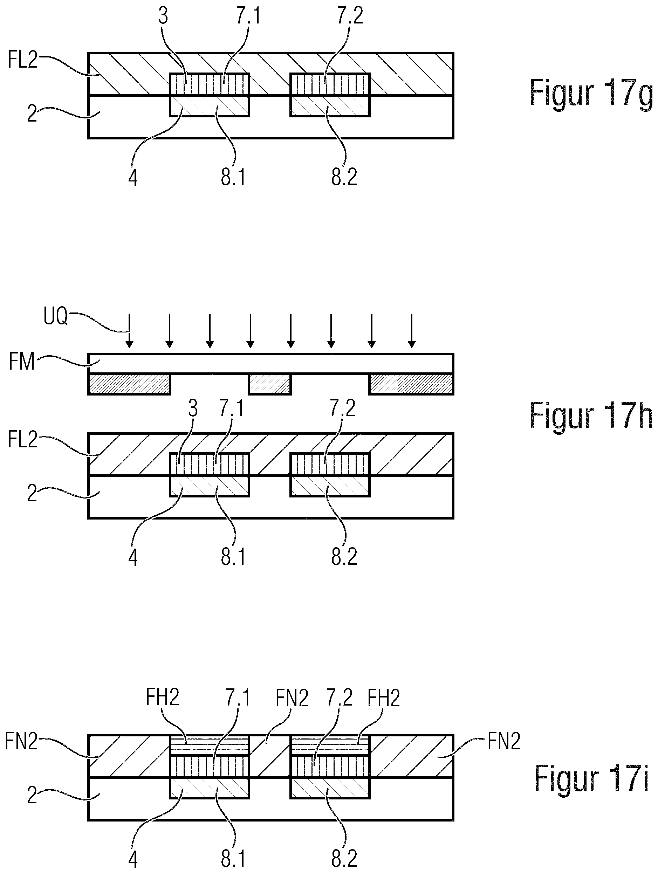

Figur 17g zeigt das Ergebnis des Schrittes g). Darüber hinaus zeigt Figur 17h das selektive Belichten der zweiten Fotolackschicht FL2. Weiterhin zeigt Figur 17i die Ausbildung der zweiten gehärteten Fotolackstruktur FH2 und der zweiten nicht gehärteten Fotolackstruktur FN2 gemäß Schritt h).

Figur 17j illustriert dann das Entfernen der zweiten nicht gehärteten Fotolackstruktur FN2 mittels eines zweiten Entwicklungslösungsmittels gemäß Schritt i). Die Schritte b) bis i) können auch mehrfach durchgeführt werden, wenn Sensorsegmente 7 mit mehreren Bereichen 9 aus unterschiedlichen Sensormaterialien hergestellt werden sollen.

Weiterhin illustriert Figur 17k das ganzflächiges Aufbringen einer Funktionsschicht 6 auf die Sensorsegmente 7 mit den gehärteten Fotolackstruktursegmenten FH2 der zweiten Fotolackschicht FL2 und die horizontal zwischen den Sensorsegmenten 7 gelegenen Zwischenräume gemäß Schritt j). Dabei können die Seiten, die Kanten und oder Teile der Oberseite der Sensorsegmente 7.1 und 7.2 durch die Funktionsschicht 6 bedeckt werden. Die Funktionsschicht 6 kann als Reflexions- oder Absorptionsschicht dienen.

Wie in Figur 17I gezeigt, kann dann gemäß Schritt k) das zweite Lösungsmittel aufgebracht werden, um so die zweite gehärtete Fotolackstruktur FH2 und den darauf angeordneten Teil der Funktionsschicht 6 zu entfernen, sodass die Funktionsschicht 6 so strukturiert ist, dass die horizontal zwischen den Sensorsegmenten 7 gelegenen Zwischenräume zumindest teilweise durch die Funktionsschicht 6 ausgefüllt sind.

Weiterhin illustriert Figur 17m gemäß Schritt I) das ganzflächige Aufbringen einer zweite Elektrodenschicht 5 zum Kontaktieren der organischen Sensorschicht 3 auf die Sensorsegmente 7 und die Funktionsschicht 6, wobei jedes der Sensorsegmente 7 von der zweiten Elektrodenschicht 5 kontaktiert ist

Die Schritte a) bis I) werden dabei so durchgeführt, dass wenigstens eine der Elektrodenschichten 4, 5 so strukturiert wird, dass eine Vielzahl von horizontal beabstandeten Elektrodensegmenten 8 gebildet wird, so dass jedem der Sensorsegmente 7 wenigstens eines der Elektrodensegmente 8 der jeweiligen Elektrodenschicht 4, 5 zugeordnet ist und dass die Sensorschicht 3 so strukturiert wird, dass eine Vielzahl von horizontal beabstandeten Sensorsegmenten 7 gebildet ist und dass jedes der Sensorsegmente 7 von der ersten Elektrodenschicht 4 kontaktiert ist.

Nun könnte eine Abscheidung von Farbfilterschichten und/oder einer Dünnschichtverkapselung auf die Sensorsegmente erfolgen, wobei sich die Reihenfolge je nach Farbfiltermaterial- und Abscheideprozess richten kann.

Aspekte der Erfindung, welche hierin im Kontext der erfindungsgemäßen Vorrichtung beschrieben sind, repräsentieren ebenso Aspekte des erfindungsgemäßen Verfahrens. Umgekehrt repräsentieren solche Aspekte der Erfindung, welche hierin im Kontext des erfindungsgemäßen Verfahrens beschrieben sind, ebenso Aspekte der erfindungsgemäßen Vorrichtung.

### Bezugszeichen:

- 1: mikrostrukturiertes organisches Sensorbauelement
- 2: Substratschicht
- 3: organische Sensorschicht
- 4: erste Elektrodenschicht
- 5: zweite Elektrodenschicht
- 6: Funktionsschicht
- 7: Sensorsegmente
- 8: Elektrodensegmente
- 9: Bereich
- 10: Leuchtdiode
- 11: Lichtkoppelschicht
- 12: Filterschicht
- 13: Filtersegment
- 14: Dünnschichtverkapselung

- SM: Sensormaterialschicht
- SE: spektrale Empfindlichkeit
- FL1: erste Fotolackschicht
- UQ: UV-Lichtquelle
- FM: Fotomaske
- FH1: erste gehärtete Fotolackstruktur
- FN1: erste nicht gehärtete Fotolackstruktur
- FH2: zweite gehärtete Fotolackstruktur
- FH3: dritte gehärtete Fotolackstruktur
- FL2: zweite Fotolackschicht

## Patentansprüche

1. Mikrostrukturiertes optisches organisches Sensorbauelement, welches eine Sensorfunktion und eine Beleuchtungsfunktion aufweist, und welches folgende parallel zueinander ausgerichteten Schichten umfasst:
eine Substratschicht (2) zum Tragen der weiteren Schichten;
eine organische Sensorschicht (3) zum Umwandeln einer zu erfassenden technischen Größe in eine elektrische Größe;
eine erste Elektrodenschicht (4) zum Kontaktieren der organischen Sensorschicht (3) auf einer der Substratschicht (2) zugewandten Seite der organischen Sensorschicht (3);
eine zweite Elektrodenschicht (5) zum Kontaktieren der organischen Sensorschicht (3) auf einer der Substratschicht (2) abgewandten Seite der organischen Sensorschicht (3); und
eine oder mehrere Funktionsschichten (6);
wobei die Sensorschicht (3) so strukturiert ist, dass eine Vielzahl von horizontal beabstandeten optischen Sensorsegmenten (7) gebildet ist;
wobei wenigstens eine der Elektrodenschichten (4, 5) so strukturiert ist, dass eine Vielzahl von horizontal beabstandeten Elektrodensegmente (8) gebildet ist, so dass jedem der Sensorsegmente (7) wenigstens eines der Elektrodensegmente (8) der jeweiligen Elektrodenschicht (4, 5) zugeordnet ist;
wobei die eine oder mehrere Funktionsschichten (6) horizontal zwischen den Sensorsegmenten (7) gelegene Zwischenräume zumindest teilweise ausfüllen;
wobei auf der Substratschicht (2) mehrere Leuchtdioden (10) zur Ausführung der Beleuchtungsfunktion ausgebildet sind; und
wobei die Sensorsegmente (7) und die Leuchtdioden (10) ineinander verschachtelt angeordnet sind.

2. Mikrostrukturiertes organisches Sensorbauelement nach vorstehendem Anspruch, wobei die Sensorsegmente (7) eine maximale horizontale Erstreckung aufweisen, welche kleiner als 50 µm ist.

3. Mikrostrukturiertes organisches Sensorbauelement nach einem der vorstehenden Ansprüche, wobei die eine oder mehrere Funktionsschichten (6) eine Passivierungsschicht (6) umfassen.

4. Mikrostrukturiertes organisches Sensorbauelement nach einem der vorstehenden Ansprüche, wobei die organische Sensorschicht (3) mehrere parallel zu den anderen Schichten angeordnete Teilsensorschichten umfasst.

5. Mikrostrukturiertes organisches Sensorbauelement nach einem der vorstehenden Ansprüche, wobei die Sensorsegmente (7) nach Art einer zweidimensionalen Matrix angeordnet sind.

6. Mikrostrukturiertes organisches Sensorbauelement nach einem der vorstehenden Ansprüche, wobei die erste und/oder die zweite Elektrodenschicht (4, 5) als organische Schicht, als Metallschicht oder als Metall-Oxid-Multischicht ausgebildet sind.

7. Mikrostrukturiertes organisches Sensorbauelement nach einem der vorstehenden Ansprüche, wobei die Substratschicht (2) als Glasschicht, als Kunststoffschicht oder als Siliziumschicht ausgebildet ist.

8. Mikrostrukturiertes organisches Sensorbauelement nach einem der vorstehenden Ansprüche, wobei die erste und/oder die zweite Elektrodenschicht (4, 5) transparent oder semitransparent sind.

9. Mikrostrukturiertes organisches Sensorbauelement nach einem der vorstehenden Ansprüche, wobei eine Gruppe der Sensorsegmente (7) eine spektrale Empfindlichkeit (SE) und mindestens eine weitere Gruppe der Sensorsegmente (7) eine jeweils von den spektralen Empfindlichkeiten (SE) der anderen Gruppen abweichende spektrale Empfindlichkeit (SE) aufweist.

10. Mikrostrukturiertes organisches Sensorbauelement nach einem der vorstehenden Ansprüche, wobei die Sensorsegmente (7) einen Bereich (9) mit einer spektralen Empfindlichkeit (SE) und mindesten einen weiteren Bereich (9) mit einer davon abweichenden spektralen Empfindlichkeit (SE) aufweisen.

11. Mikrostrukturiertes organisches Sensorbauelement nach einem der vorstehenden Ansprüche, wobei die Schichten eine oder mehrere Lichtkoppelschichten (11) umfassen, welche zum Verbessern der Lichtkoppeleffizienz beim Einkoppeln von Licht in eine der Elektrodenschichten (4, 5) und/oder beim Auskoppeln von Licht aus einer der Elektrodenschichten (4, 5) ausgebildet sind, wobei auf der der organischen Sensorschicht (3) abgewandten Seite der ersten Elektrodenschicht (4) und/oder auf der der organische Sensorschicht (3) abgewandten Seite der zweite Elektrodenschicht (5) jeweils eine der Lichtkoppelschichten (11) vorgesehen ist.

12. Mikrostrukturiertes organisches Sensorbauelement nach einem der vorstehenden Ansprüche, wobei die Schichten eine oder mehrere Filterschichten (12) umfassen, welche zum spektralen Filtern von Licht beim Einkoppeln von Licht in eine der Elektrodenschichten (4, 5) und/oder beim Auskoppeln von Licht aus einer der Elektrodenschichten ausgebildet sind, wobei auf der der organischen Sensorschicht (3) abgewandten Seite der ersten Elektrodenschicht (4) und/oder auf der der organischen Sensorschicht (3) abgewandten Seite der zweite Elektrodenschicht (5) jeweils eine der Filterschichten (12) vorgesehen ist.

13. Mikrostrukturiertes organisches Sensorbauelement nach vorstehendem Anspruch, wobei die eine oder mehreren Filterschichten (12) so strukturiert sind, dass eine Vielzahl von horizontal nebeneinander liegenden Filtersegmenten (13) gebildet ist, so dass jedem der Sensorsegmente (7) wenigstens eines der Filtersegmente (13) der jeweiligen Filterschicht (12) zugeordnet ist, wobei eine erste Gruppe der Filtersegmente (13) der jeweiligen Filterschicht (12) eine erste spektrale Charakteristik und eine zweite Gruppe der Filtersegmente (13) der jeweiligen Filterschicht (12) eine von der zweiten spektralen Charakteristik abweichende zweite spektrale Charakteristik aufweist.

14. Mikrostrukturiertes organisches Sensorbauelement nach einem der vorstehenden Ansprüche, wobei eine Dünnschichtverkapselung (14) zum Schutz wenigstens eines Teiles der Schichten vor der Einwirkung von Feuchtigkeit vorgesehen ist.

15. Mikrostrukturiertes organisches Sensorbauelement nach vorstehendem Anspruch, wobei die Dünnschichtverkapselung (14) zur Verhinderung eines horizontalen Eindringens von Flüssigkeit zwischen zumindest einige der Schichten ausgebildet ist.

16. Verfahren zur Herstellung eines mikrostrukturierten organischen Sensorbauelements (1) mit parallel zueinander ausgerichteten Schichten, wobei die Schichten eine Sensorschicht (3) umfassen, welche so strukturiert ist, dass eine Vielzahl horizontal beabstandeten Sensorsegmente (7) gebildet ist, wobei jedes Sensorsegment (7) aus einem oder mehreren Bereichen (9) besteht, insbesondere nach einem der Ansprüche 1-18, wobei das Verfahren folgende Schritte in folgender Reihenfolge umfasst:
a) Bereitstellen einer Substratschicht (2) zum Tragen der weiteren Schichten, wobei an der Substratschicht (2) eine erste Elektrodenschicht (4) zum Kontaktieren einer organischen Sensorschicht (3) zum Umwandeln einer zu erfassenden technischen Größe in eine elektrische Größe angeordnet ist;
b) ganzflächiges Aufbringen mindestens einer organischen Sensormaterialschicht (SM) auf einen Verbund aus der Substratschicht (2) und der erste Elektrodenschicht (4);
c) ganzflächiges Aufbringen einer ersten Fotolackschicht (FL1) auf die organische Sensormaterialschicht (SM);
d) selektives Belichten der ersten Fotolackschicht (FL1), so dass eine erste gehärtete Fotolackstruktur (FH1) mit horizontal beabstandeten ersten gehärteten Fotolackstruktursegmenten (FH1) und eine erste nicht gehärtete Fotolackstruktur (FN1) entstehen;
e) Entfernen der ersten nicht gehärteten Fotolackstruktur (FN1) mittels eines ersten Entwicklungslösungsmittels;
f) Aufbringen eines ersten Lösungsmittels, um so einen nicht von der ersten gehärteten Fotolackstruktur (FH1) bedeckten Teil der mindestens einen organischen Sensormaterialschicht (SM) zu entfernen, sodass durch einen verbleibenden Teil der mindestens einen organischen Sensormaterialschicht (SM) jeweils wenigstens einer der Bereiche (9) der Sensorsegmente (7) der Sensorschicht (3) gebildet wird, sodass jedes der Sensorsegmente (7) von der ersten Elektrodenschicht (4) kontaktiert ist;
g) Entfernen der ersten gehärteten Fotolackstruktur (FH1) mittels eines zweiten Lösungsmittels;
h) ganzflächiges Aufbringen einer zweiten Fotolackschicht auf die Sensorsegmente (7) und auf horizontal zwischen den Sensorsegmenten (7) gelegene Zwischenräume;
i) selektive Belichtung der zweiten Fotolackschicht, so dass eine zweite gehärtete Fotolackstruktur (FH2) mit horizontal beabstandeten zweiten gehärteten Fotolackstruktursegmenten (FH2) und eine zweite nicht gehärtete Fotolackstruktur entstehen, wobei an jedem Sensorsegment (7) wenigstens eines der zweiten gehärteten Fotolackstruktursegmente (FH2) ausgebildet ist;
j) Entfernen der zweiten nicht gehärteten Fotolackstruktur mittels eines zweiten Entwicklungslösungsmittels;
k) ganzflächiges Aufbringen einer Funktionsschicht (6) auf die Sensorsegmente (7) mit den zweiten gehärteten Fotolackstruktursegmenten (FH2) und die horizontal zwischen den Sensorsegmenten (7) gelegenen Zwischenräume;
l) ganzflächiges Aufbringen einer dritten Fotolackschicht auf die Funktionsschicht (6);
m) selektive Belichtung der dritten Fotolackschicht, so dass eine dritte gehärtete Fotolackstruktur (FH3) und eine dritte nicht gehärtete Fotolackstruktur mit horizontal beabstandeten nicht gehärteten Fotolackstruktursegmenten entstehen, wobei jedem der zweiten gehärteten Fotolackstruktursegmente (FH2) eines der nicht gehärteten Fotolackstruktursegmente der dritten Fotolackschicht zugeordnet ist;
n) Entfernen der dritten nicht gehärteten Fotolackstruktur mittels eines dritten Entwicklungslösungsmittels;
o) Aufbringen eines dritten Lösungsmittels, um so einen nicht von der dritten gehärteten Fotolackstruktur (FH3) bedeckten Teil der Funktionsschicht (6) und die zweiten gehärteten Fotolackstruktursegmente (FH2) zu entfernen, sodass die Funktionsschicht (6) so strukturiert ist, dass die horizontal zwischen den Sensorsegmenten (7) gelegenen Zwischenräume zumindest teilweise durch die Funktionsschicht (6) ausgefüllt sind;
p) Entfernen der dritten gehärteten Fotolackstruktur (FH3) mittels eines vierten Lösungsmittels; und
q) ganzflächiges Aufbringen einer zweite Elektrodenschicht (5) zum Kontaktieren der organischen Sensorschicht (3) auf die Sensorsegmente (7) und die Funktionsschicht (6), sodass jedes der Sensorsegmente (7) von der zweiten Elektrodenschicht (5) kontaktiert ist;
wobei wenigstens eine der Elektrodenschichten (4, 5) so strukturiert wird, dass eine Vielzahl von horizontal beabstandeten Elektrodensegmente (8) gebildet wird, so dass jedem der Sensorsegmente (7) wenigstens eines der Elektrodensegmente (8) der jeweiligen Elektrodenschicht (4, 5) zugeordnet ist.

17. Verfahren zur Herstellung eines mikrostrukturierten organischen Sensorbauelements (1) mit parallel zueinander ausgerichteten Schichten, wobei die Schichten eine Sensorschicht (3) umfassen, welche so strukturiert ist, dass eine Vielzahl horizontal beabstandeten Sensorsegmente (7) gebildet ist, wobei jedes Sensorsegment (7) aus einem oder mehreren Bereichen (9) besteht, insbesondere nach einem der Ansprüche 1-18, wobei das Verfahren folgende Schritte in folgender Reihenfolge umfasst:
a) Bereitstellen einer Substratschicht (2) zum Tragen der weiteren Schichten, wobei an der Substratschicht (2) eine erste Elektrodenschicht (4) zum Kontaktieren einer organischen Sensorschicht (3) zum Umwandeln einer zu erfassenden technischen Größe in eine elektrische Größe angeordnet ist;
b) ganzflächiges Aufbringen einer ersten Fotolackschicht (FL1) auf einen Verbund aus der Substratschicht (2) und der ersten Elektrodenschicht (4);
c) selektives Belichten der ersten Fotolackschicht (FL1), so dass eine erste gehärtete Fotolackstruktur (FH1) und eine erste nicht gehärtete Fotolackstruktur (FN1) mit ersten horizontal beabstandeten gehärteten Fotolackstruktursegmenten (FN1) entstehen;
d) Entfernen der ersten nicht gehärteten Fotolackstruktur (FN1) mittels eines ersten Entwicklungslösungsmittels;
e) ganzflächiges Aufbringen einer organischen Sensormaterialschicht (SM) auf einen Verbund aus der Substratschicht (2), der ersten Elektrodenschicht (4) und der ersten gehärteten Fotolackstruktur (FH1);
f) Aufbringen eines ersten Lösungsmittels, um so die erste gehärtete Fotolackstruktur (FH1) und den darauf angeordneten Teil der organischen Sensormaterialschicht (SM) zu entfernen, sodass durch einen verbleibenden Teil der mindestens einen organischen Sensormaterialschicht (SM) jeweils wenigstens einer der Bereiche (9) der Sensorsegmente (7) der Sensorschicht (3) gebildet wird, sodass jedes der Sensorsegmente (7) von der ersten Elektrodenschicht (4) kontaktiert ist;
g) ganzflächiges Aufbringen einer zweiten Fotolackschicht (FL2) auf einen Verbund aus der Substratschicht (2), der ersten Elektrodenschicht (4) und den Sensorsegmenten (7);
h) selektives Belichten der zweiten Fotolackschicht (FL2), so dass eine zweite gehärtete Fotolackstruktur (FH2) mit horizontal beabstandeten gehärteten Fotolackstruktursegmenten (FH2) und eine zweite nicht gehärtete Fotolackstruktur (FN2) entstehen, wobei an jedem Sensorsegment (7) wenigstens ein gehärtetes Fotolackstruktursegment (FH2) der zweiten Fotolackschicht (FL2) ausgebildet ist;
i) Entfernen der zweiten nicht gehärteten Fotolackstruktur (FN2) mittels eines zweiten Entwicklungslösungsmittels;
j) ganzflächiges Aufbringen einer Funktionsschicht (6) auf die Sensorsegmente (7) mit den gehärteten Fotolackstruktursegmenten (FH2) der zweiten Fotolackschicht (FL2) und die horizontal zwischen den Sensorsegmenten (7) gelegenen Zwischenräume;
k) Aufbringen eines zweiten Lösungsmittels, um so die zweite gehärtete Fotolackstruktur (FH2) und den darauf angeordneten Teil der Funktionsschicht (6) zu entfernen, sodass die Funktionsschicht (6) so strukturiert ist, dass die horizontal zwischen den Sensorsegmenten (7) gelegenen Zwischenräume zumindest teilweise durch die Funktionsschicht (6) ausgefüllt sind; und
l) ganzflächiges Aufbringen einer zweite Elektrodenschicht (5) zum Kontaktieren der organischen Sensorschicht (3) auf die Sensorsegmente (7) und die Funktionsschicht (6), wobei jedes der Sensorsegmente (7) von der zweiten Elektrodenschicht (5) kontaktiert ist;
wobei wenigstens eine der Elektrodenschichten (4, 5) so strukturiert wird, dass eine Vielzahl von horizontal beabstandeten Elektrodensegmente (8) gebildet wird, so dass jedem der Sensorsegmente (7) wenigstens eines der Elektrodensegmente (8) der jeweiligen Elektrodenschicht (4, 5) zugeordnet ist.

## Claims

1. A micro-structured optical organic sensor device comprising a sensor function and a lighting function and comprising the following layers oriented in parallel to one another:
a substrate layer (2) for supporting the further layers;
an organic sensor layer (3) for converting a technical quantity to be detected to an electrical quantity;
a first electrode layer (4) for contacting the organic sensor layer (3) on a side of the organic sensor layer (3) facing the substrate layer (2);
a second electrode layer (5) for contacting the organic sensor layer (3) on a side of the organic sensor layer (3) facing away from the substrate layer (2); and
one or several functional layers (6);
wherein the sensor layer (3) is structured such that a plurality of horizontally spaced optical sensor segments (7) are formed;
wherein at least one of the electrode layers (4, 5) is structured such that a plurality of horizontally spaced electrode segments (8) are formed so that at least one of the electrode segments (8) of the respective electrode layer (4, 5) is associated to each of the sensor segments (7);
wherein the one or several functional layers (6) at least partly fill gaps located horizontally between the sensor segments (7);
wherein several light-emitting diodes (10) for performing the lighting function are formed on the substrate layer (2); and
wherein the sensor segments (7) and the light-emitting diodes (10) are arranged interleaved with one another.

2. The micro-structured organic sensor device in accordance with the preceding claim, wherein the sensor segments (7) comprise a maximum horizontal extension of smaller than 50 µm.

3. The micro-structured organic sensor device in accordance with any of the preceding claims, wherein the one or several functional layers (6) comprise a passivation layer (6).

4. The micro-structured organic sensor device in accordance with any of the preceding claims, wherein the organic sensor layer (3) comprises several sub-sensor layers arranged in parallel to the other layers.

5. The micro-structured organic sensor device in according with any of the preceding claims, wherein the sensor segments (7) are arranged in the style of a two-dimensional matrix.

6. The micro-structured organic sensor device in accordance with any of the preceding claims, wherein the first and/or second electrode layers (4, 5) is/are implemented as an organic layer, metal layer or metal-oxide multi-layer.

7. The micro-structured organic sensor device in accordance with any of the preceding claims, wherein the substrate layer (2) is implemented as a glass layer, plastics layer or silicon layer.

8. The micro-structured organic sensor device in accordance with any of the preceding claims, wherein the first and/or second electrode layers (4, 5) is/are transparent or semi-transparent.

9. The micro-structured organic sensor device in accordance with any of the preceding claims, wherein a group of the sensor segments (7) comprises a spectral sensitivity (SE) and at least one further group of the sensor segments (7) comprises a spectral sensitivity (SE) deviating each from the spectral sensitivities (SE) of the other groups.

10. The micro-structured organic sensor device in accordance with any of the preceding claims, wherein the sensor segments (7) comprise a region (9) having a spectral sensitivity (SE) and at least one further region (9) having a deviating spectral sensitivity (SE).

11. The micro-structured organic sensor device in accordance with any of the preceding claims, wherein the layers comprise one or several light-coupling layers (11) configured for improving the light-coupling efficiency when coupling light into one of the electrode layers (4, 5) and/or when coupling light out from one of the electrode layers (4, 5), wherein one of the light-coupling layers (11) is provided each on the side of the first electrode layer (4) facing away from the organic sensor layer (3) and/or the side of the second electrode layer (5) facing away from the organic sensor layer (3).

12. The micro-structured organic sensor device in accordance with any of the preceding claims, wherein the layers comprise one or several filter layers (12) configured for spectrally filtering light when coupling light into one of the electrode layers (4, 5) and/or when coupling light out from one of the electrode layers, wherein one of the filter layers (12) is provided each on the side of the first electrode layer (4) facing away from the organic sensor layer (3) and/or on the side of the second electrode layer (5) facing away from the organic sensor layer (3).

13. The micro-structured organic sensor device in accordance with any of the preceding claims, wherein the one or several filter layers (12) is/are structured such that a plurality of filter segments (13) located horizontally next to one another are formed so that at least one of the filter segments (13) of the respective filter layer (12) is associated to each of the sensor segments (7), wherein a first group of the filter segments (13) of the respective filter layer (12) comprises a first spectral characteristic and a second group of the filter segments (13) of the respective filter layer (12) comprises a second spectral characteristic deviating from the first spectral characteristic.

14. The micro-structured organic sensor device in accordance with any of the preceding claims, wherein a thin-film encapsulation (14) is provided for protecting at least a part of the layers from the effect of humidity.

15. The micro-structured organic sensor device in accordance with the preceding claim, wherein the thin-film encapsulation (14) is configured for preventing horizontal penetration of liquid between at least some of the layers.

16. A method for manufacturing a micro-structured organic sensor device (1) comprising layers oriented in parallel to one another, wherein the layers comprise a sensor layer (3) which is structured such that a plurality of horizontally spaced sensor segments (7) are formed, wherein each sensor segment (7) consists of one or several regions (9), in particular in accordance with any of claims 1-18, the method comprising the following steps in the following order:
a) providing a substrate layer (2) for supporting the further layers, wherein a first electrode layer (4) for contacting an organic sensor layer (3) is arranged at the substrate layer (2), for converting a technical quantity to be detected to an electrical quantity;
b) applying at least one organic sensor material layer (SM) over an entire area onto a compound made of the substrate layer (2) and the first electrode layer (4);
c) applying a first photoresist layer (FL1) over an entire area onto the organic sensor material layer (SM);
d) selectively exposing the first photoresist layer (FL1) so that a first cured photoresist structure (FH1) having horizontally spaced first cured photoresist structure elements (FH1) and a first non-cured photoresist structure (FN1) result;
e) removing the first non-cured photoresist structure (FN1) by means of a first developing solvent;
f) applying a first solvent in order to remove a part of the at least one organic sensor material layer (SM) not covered by the first cured photoresist structure (FH1) so that at least one of the regions (9) of the sensor segments (7) of the sensor layer (3) is formed each by a remaining part of the at least one organic sensor material layer (SM) so that each of the sensor segments (7) is contacted by the first electrode layer (4);
g) removing the first cured photoresist structure (FH1) by means of a second solvent;
h) applying a second photoresist layer over an entire area onto the sensor segments (7) and onto gaps located horizontally between the sensor segments (7);
i) selectively exposing the second photoresist layer so that a second cured photoresist structure (FH2) having horizontally spaced second cured photoresist structure segments (FH2) and a second non-cured photoresist structure result, wherein at least one of the second cured photoresist structure segments (FH2) is formed at each sensor segment (7);
j) removing the second non-cured photoresist structure by means of a second developing solvent;
k) applying a functional layer (6) over an entire area onto the sensor segments (7) having the second cured photoresist structure segments (FH2) and the gaps located horizontally between the sensor segments (7);
l) applying a third photoresist layer over an entire area onto the functional layer (6);
m)selectively exposing the third photoresist layer so that a third cured photoresist layer (FH3) and a third non-cured photoresist layer having horizontally spaced non-cured photoresist structure segments result, wherein one of the non-cured photoresist structure segments of the third photoresist layer is associated to each of the second cured photoresist structure segments (FH2);
n) removing the third non-cured photoresist structure by means of a third developing solvent;
o) applying a third solvent in order to remove a part of the functional layer (6) not covered by the third cured photoresist structure (FH3) and the second cured photoresist structure segments (FH2) so that the functional layer (6) is structured such that the gaps located horizontally between the sensor segments (7) are filled at least partly by the functional layer (6);
p) removing the third cured photoresist structure (FH3) by means of a fourth solvent; and
q) applying a second electrode layer (5) for contacting the organic sensor layer (3) over an entire area onto the sensor segments (7) and the functional layer (6) so that each of the sensor segments (7) is contacted by the second electrode layer (5);
wherein at least one of the electrode layers (4, 5) is structured such that a plurality of horizontally spaced electrode segments (8) are formed so that at least one of the electrode segments (8) of the respective electrode layer (4, 5) is associated to each of the sensor segments (7).

17. A method for manufacturing a micro-structured organic sensor device (1) comprising layers oriented in parallel to one another, wherein the layers comprise a sensor layer (3) which is structured such that a plurality of horizontally spaced sensor segments (7) are formed, wherein each sensor segment (7) consists of one or several regions (9), in particular in accordance with any of claims 1-18, the method comprising the following steps in the following order:
a) providing a substrate layer (2) for supporting the further layers, wherein a first electrode layer (4) for contacting an organic sensor layer (3) is arranged at the substrate layer (2), for converting a technical quantity to be detected to an electrical quantity;
b) applying a first photoresist layer (FL1) over an entire area onto a compound made of the substrate layer (2) and the first electrode layer (4);
c) selectively exposing the first photoresist layer (FL1) so that a first cured photoresist structure (FH1) and a first non-cured photoresist structure (FN1) having first horizontally spaced cured photoresist structure segments (FN1) are formed;
d) removing the first non-cured photoresist structure (FN1) by means of a first developing solvent;
e) applying an organic sensor material layer (SM) over an entire area onto a compound made of the substrate layer (2), the first electrode layer (4) and the first cured photoresist structure (FH1);
f) applying a first solvent in order to remove the first cured photoresist structure (FH1) and the part of the organic sensor material layer (SM) arranged thereon so that at least one of the regions (9) of the sensor segments (7) of the sensor layer (3) is formed each by a remaining part of the at least one organic sensor material layer (SM) so that each of the sensor segments (7) is contacted by the first electrode layer (4);
g) applying a second photoresist layer (FL2) over an entire area onto a compound made of the substrate layer (2), the first electrode layer (4) and the sensor segments (7);
h) selectively exposing the second photoresist layer (FL2) so that a second cured photoresist structure (FH2) having second horizontally spaced cured photoresist structure segments (FH2) and a second non-cured photoresist structure (FN2) result, wherein at least one cured photoresist structure segment (FH2) of the second photoresist layer (FL2) is formed at each sensor segment (7);
i) removing the second non-cured photoresist structure (FN2) by means of a second developing solvent;
j) applying a functional layer (6) over an entire area onto the sensor segments (7) having the cured photoresist structure segments (FH2) of the second photoresist layer (FL2) and the gaps located horizontally between the sensor segments (7);
k) applying a second solvent in order to remove the second cured photoresist structure (FH2) and the part of the functional layer (6) arranged thereon so that the functional layer (6) is structured such that the gaps located horizontally between the sensor segments (7) are filled at least partly by the functional layer (6); and
l) applying a second electrode layer (5) for contacting the organic sensor layer (3) over an entire area onto the sensor segments (7) and the functional layer (6), wherein each of the sensor segments (7) is contacted by the second electrode layer (5);
wherein at least one of the electrode layers (4, 5) is structured such that a plurality of horizontally spaced electrode segments (8) are formed so that at least one of the electrode segments (8) of the respective electrode layer (4, 5) is associated to each of the sensor segments (7).

## Revendications

1. Composant de capteur optique organique microstructuré, qui comprend une fonction de capteur et une fonction d'éclairage, et qui inclut les couches suivantes, alignées parallèlement les unes aux autres :
une couche de substrat (2) destinée à supporter les autres couches ;
une couche de capteur organique (3) destinée à convertir une grandeur technique à détecter en une grandeur électrique ;
une première couche d'électrode (4) destinée à établir le contact avec la couche de capteur organique (3) sur l'une des faces de cette dernière tournée vers la couche de substrat (2) ;
une deuxième couche d'électrode (5) destinée à établir le contact avec la couche de capteur organique (3) sur une face de celle-ci opposée à la couche de substrat (2) ; et
une ou plusieurs couches fonctionnelles (6) ;
la couche de capteur organique (3) étant structurée de manière à former une multitude de segments de capteur optiques (7) espacés horizontalement ;
au moins l'une des couches d'électrode (4, 5) étant structurée de manière à former une multitude de segments d'électrode (8) espacés horizontalement, de sorte que chacun des segments de capteur (7) soit associé à au moins l'un des segments d'électrode (8) de la couche d'électrode respective (4, 5) ;
ladite ou lesdites couches fonctionnelles (6) remplissant au moins partiellement les espaces situés horizontalement entre les segments de capteur (7) ;
plusieurs diodes électroluminescentes (10) destinées à assurer la fonction d'éclairage étant formées sur la couche de substrat (2) ; et
dans lequel les segments de capteur (7) et les diodes électroluminescentes (10) sont disposés de manière imbriquée les uns dans les autres.

2. Composant de capteur organique microstructuré selon la revendication précédente, dans lequel les segments de capteur (7) comprennent une extension horizontale maximale inférieure à 50 µm.

3. Composant de capteur organique microstructuré selon l'une des revendications précédentes, dans lequel la ou les couches fonctionnelles (6) incluent une couche de passivation (6).

4. Composant de capteur organique microstructuré selon l'une des revendications précédentes, dans lequel la couche de capteur organique (3) inclut plusieurs souscouches de capteur disposées parallèlement aux autres couches.

5. Composant de capteur organique microstructuré selon l'une des revendications précédentes, dans lequel les segments de capteur (7) sont disposés à la manière d'une matrice bidimensionnelle.

6. Composant de capteur organique microstructuré selon l'une des revendications précédentes, dans lequel la première et/ou la deuxième couche d'électrode (4, 5) sont réalisées sous la forme d'une couche organique, d'une couche métallique ou d'une multicouche métal-oxyde.

7. Composant de capteur organique microstructuré selon l'une des revendications précédentes, dans lequel la couche de substrat (2) est constituée d'une couche de verre, d'une couche de matière plastique ou d'une couche de silicium.

8. Composant de capteur organique microstructuré selon l'une des revendications précédentes, dans lequel la première et/ou la deuxième couche d'électrode (4, 5) sont transparentes ou semi-transparentes.

9. Composant de capteur organique microstructuré selon l'une des revendications précédentes, dans lequel un groupe de segments de capteur (7) comprend une sensibilité spectrale (SE) et au moins un autre groupe de segments de capteur (7) comprend une sensibilité spectrale (SE) différente de celles des autres groupes.

10. Composant de capteur organique microstructuré selon l'une des revendications précédentes, dans lequel les segments de capteur (7) comprennent une zone (9) présentant une sensibilité spectrale (SE) et au moins une autre zone (9) présentant une sensibilité spectrale (SE) différente de celle-ci.

11. Composant de capteur organique microstructuré selon l'une des revendications précédentes, dans lequel les couches incluent une ou plusieurs couches de couplage optique (11) qui sont conçues pour améliorer l'efficacité du couplage optique lors de l'injection de lumière dans l'une des couches d'électrode (4, 5) et/ou lors de l'extraction de lumière de l'une des couches d'électrode (4, 5), dans lequel l'une des couches de couplage optique (11) est prévue respectivement sur la face de la première couche d'électrode (4) opposée à la couche de capteur organique (3) et/ou sur la face de la deuxième couche d'électrode (5) opposée à la couche de capteur organique (3).

12. Composant de capteur organique microstructuré selon l'une des revendications précédentes, dans lequel les couches incluent une ou plusieurs couches filtrantes (12) qui sont conçues pour filtrer spectralement la lumière lors de l'injection de lumière dans l'une des couches d'électrode (4, 5) et/ou lors de l'extraction de lumière de l'une des couches d'électrode, dans lequel l'une des couches filtrantes (12) est prévue respectivement sur la face de la première couche d'électrode (4) opposée à la couche de capteur organique (3) et/ou sur la face de la deuxième couche d'électrode (5) opposée à la couche de capteur organique (3).

13. Composant de capteur organique microstructuré selon la revendication précédente, dans lequel la ou les couches filtrantes (12) sont structurées de manière à former une multitude de segments filtrants (13) disposés horizontalement les uns à côté des autres, de sorte qu'à chacun des segments de capteur (7) soit associé au moins l'un des segments filtrants (13) de la couche filtrante respective (12), et dans lequel un premier groupe des segments filtrants (13) de la couche filtrante respective (12) présente une première caractéristique spectrale et un deuxième groupe des segments filtrants (13) de la couche filtrante respective (12) présente une deuxième caractéristique spectrale différente de la première.

14. Composant de capteur organique microstructuré selon l'une des revendications précédentes, dans lequel une encapsulation en couche mince (14) est prévue pour protéger au moins une partie des couches contre l'action de l'humidité.

15. Composant de capteur organique microstructuré selon la revendication précédente, dans lequel l'encapsulation en couche mince (14) est conçue pour empêcher la pénétration horizontale de liquide entre au moins certaines des couches.

16. Procédé de fabrication d'un composant de capteur organique microstructuré (1) avec des couches alignées parallèlement les unes aux autres, lesdites couches incluant une couche de capteur (3) structurée de manière à former une multitude de segments de capteur (7) espacés horizontalement, chaque segment de capteur (7) étant constitué d'une ou plusieurs zones (9), en particulier selon l'une des revendications 1 à 18, le procédé comprenant, dans l'ordre indiqué, le fait de :
a) fournir une couche de substrat (2) destinée à supporter les autres couches, une première couche d'électrode (4) destinée à établir le contact avec une couche de capteur organique (3) destinée à convertir une grandeur technique à détecter en une grandeur électrique étant disposée sur la couche de substrat (2) ;
b) appliquer au moins une couche de matériau de capteur organique (SM) sur toute la surface d'un assemblage constitué de la couche de substrat (2) et de la première couche d'électrode (4) ;
c) appliquer une première couche de photoréserve (FL1) sur toute la surface de la couche de matériau de capteur organique (SM) ;
d) exposer sélectivement la première couche de photoréserve (FL1), de manière à former une première structure de photoréserve durcie (FH1) avec des premiers segments de structure de photoréserve durcie (FH1) espacés horizontalement, ainsi qu'une première structure de photoréserve non durcie (FN1) ;
e) éliminer la première structure de photoréserve non durcie (FN1) à l'aide d'un premier solvant de développement ;
f) appliquer un premier solvant afin d'éliminer une partie de ladite au moins une couche de matériau de capteur organique (SM) non recouverte par la première structure de photoréserve durcie (FH1), de sorte qu'au moins l'une des zones (9) des segments de capteur (7) de la couche de capteur (3) soit formée par une partie restante de ladite au moins une couche de matériau de capteur organique (SM), de sorte que chacun des segments de capteur (7) soit en contact avec la première couche d'électrode (4) ;
g) éliminer la première structure de photoréserve durcie (FH1) à l'aide d'un deuxième solvant ;
h) appliquer une deuxième couche de photoréserve sur toute la surface des segments de capteur (7) et des espaces situés horizontalement entre les segments de capteur (7) ;
i) exposer sélectivement la deuxième couche de photoréserve, de manière à former une deuxième structure de photoréserve durcie (FH2) avec des segments de structure de photoréserve durcie (FH2) espacés horizontalement et une deuxième structure de photoréserve non durcie, au moins l'un des segments de la deuxième structure de photoréserve durcie (FH2) étant formé au niveau de chaque segment de capteur (7) ;
j) éliminer la deuxième structure de photoréserve non durcie à l'aide d'un deuxième solvant de développement ;
k) appliquer une couche fonctionnelle (6) sur toute la surface des segments de capteur (7) munis des deuxièmes segments de structure de photoréserve durcie (FH2) et des espaces intermédiaires situés horizontalement entre les segments de capteur (7) ;
l) appliquer une troisième couche de photoréserve sur toute la surface de la couche fonctionnelle (6) ;
m) exposer sélectivement la troisième couche de photoréserve, de manière à former une troisième structure de photoréserve durcie (FH3) et une troisième structure de photoréserve non durcie avec des segments de structure de photoréserve non durcie espacés horizontalement, chacun des deuxièmes segments de structure de photoréserve durcie (FH2) étant associé à l'un des segments de structure de photoréserve non durcie de la troisième couche de photoréserve ;
n) éliminer la troisième structure de photoréserve non durcie à l'aide d'un troisième solvant de développement ;
o) appliquer un troisième solvant afin d'éliminer une partie de la couche fonctionnelle (6) non recouverte par la troisième structure de photoréserve durcie (FH3) et les deuxièmes segments de structure de photoréserve durcie (FH2), de sorte que la couche fonctionnelle (6) soit structurée de manière à ce que les espaces situés horizontalement entre les segments de capteur (7) soient au moins partiellement remplis par la couche fonctionnelle (6) ;
p) éliminer la troisième structure de photoréserve durcie (FH3) à l'aide d'un quatrième solvant ; et
q) appliquer sur toute la surface des segments de capteur (7) et de la couche fonctionnelle (6) une deuxième couche d'électrode (5) destinée à établir le contact avec la couche de capteur organique (3), de sorte que chacun des segments de capteur (7) soit en contact avec la deuxième couche d'électrode (5) ;
au moins l'une des couches d'électrode (4, 5) étant structurée de manière à former une multitude de segments d'électrode (8) espacés horizontalement, de sorte que chacun des segments de capteur (7) soit associé à au moins l'un des segments d'électrode (8) de la couche d'électrode respective (4, 5).

17. Procédé de fabrication d'un composant de capteur organique microstructuré (1) avec des couches orientées parallèlement les unes aux autres, lesdites couches incluant une couche de capteur (3) structurée de manière à former une multitude de segments de capteur (7) espacés horizontalement, chaque segment de capteur (7) étant constitué d'une ou plusieurs zones (9), en particulier selon l'une des revendications 1 à 18, le procédé comprenant, dans l'ordre indiqué, le fait de :
a) fournir une couche de substrat (2) destinée à supporter les autres couches, une première couche d'électrode (4) destinée à établir le contact avec une couche de capteur organique (3) destinée à convertir une grandeur technique à détecter en une grandeur électrique étant disposée sur la couche de substrat (2) ;
b) appliquer une première couche de photoréserve (FL1) sur toute la surface d'un assemblage constitué de la couche de substrat (2) et de la première couche d'électrode (4) ;
c) exposer sélectivement la première couche de photoréserve (FL1), de manière à obtenir une première structure de photoréserve durcie (FH1) et une première structure de photoréserve non durcie (FN1) avec des premiers segments de structure de photoréserve durcie espacés horizontalement (FN1) ;
d) éliminer la première structure de photoréserve non durcie (FN1) à l'aide d'un premier solvant de développement ;
e) appliquer une couche de matériau de capteur organique (SM) sur toute la surface d'un assemblage constitué de la couche de substrat (2), de la première couche d'électrode (4) et de la première structure de photoréserve durcie (FH1) ;
f) appliquer un premier solvant afin d'éliminer la première structure de photoréserve durcie (FH1) et la partie de la couche de matériau de capteur organique (SM) disposée sur celle-ci, de sorte qu'une partie restante de ladite au moins une couche de matériau de capteur organique (SM) forme respectivement au moins l'une des zones (9) des segments de capteur (7) de la couche de capteur (3), de sorte que chacun des segments de capteur (7) soit en contact avec la première couche d'électrode (4) ;
g) appliquer une deuxième couche de photoréserve (FL2) sur toute la surface d'un assemblage constitué de la couche de substrat (2), de la première couche d'électrode (4) et des segments de capteur (7) ;
h) exposer sélectivement la deuxième couche de photoréserve (FL2), de manière à obtenir une deuxième structure de photoréserve durcie (FH2) avec des segments de structure de photoréserve durcie espacés horizontalement (FH2) et une deuxième structure de photoréserve non durcie (FN2) ; au moins un segment de structure de photoréserve durcie (FH2) de la deuxième couche de photoréserve (FL2) étant formé sur chaque segment de capteur (7) ;
i) éliminer la deuxième structure de photoréserve non durcie (FN2) à l'aide d'un deuxième solvant de développement ;
j) appliquer une couche fonctionnelle (6) sur toute la surface des segments de capteur (7) munis des segments de structure de photoréserve durcie (FH2) de la deuxième couche de photoréserve (FL2) et des espaces situés horizontalement entre les segments de capteur (7) ;
k) appliquer un deuxième solvant afin d'éliminer la deuxième structure de photoréserve durcie (FH2) et la partie de la couche fonctionnelle (6) qui y est disposée, de sorte que la couche fonctionnelle (6) soit structurée de manière à ce que les espaces situés horizontalement entre les segments de capteur (7) soient au moins partiellement remplis par la couche fonctionnelle (6) ; et
l) appliquer sur toute la surface des segments de capteur (7) et de la couche fonctionnelle (6) une deuxième couche d'électrode (5) destinée à établir le contact avec la couche de capteur organique (3), chacun des segments de capteur (7) étant en contact avec la deuxième couche d'électrode (5) ;
au moins l'une des couches d'électrode (4, 5) étant structurée de manière à former une multitude de segments d'électrode (8) espacés horizontalement, de sorte que chacun des segments de capteur (7) soit associé à au moins l'un des segments d'électrode (8) de la couche d'électrode respective (4, 5).
